(19) Europäisches Patentamt
European Patent Office
Office européen des brevets

(11) **EP 4 279 634 A1**

(12) **EUROPEAN PATENT APPLICATION**

(43) Date of publication:
**22.11.2023 Bulletin 2023/47**

(21) Application number: **22173745.5**

(22) Date of filing: **17.05.2022**

(51) International Patent Classification (IPC):
***C23F 1/18*** *(2006.01)* ***H01L 21/3213*** *(2006.01)*
***H05K 3/06*** *(2006.01)* ***H05K 3/38*** *(2006.01)*
***C23F 1/02*** *(2006.01)*

(52) Cooperative Patent Classification (CPC):
**C23F 1/18; C23F 1/02; H01L 21/32134; H05K 3/067; H05K 3/382; H05K 3/383; H05K 3/385; H05K 3/389;** H05K 2203/03; H05K 2203/0392; H05K 2203/122

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Atotech Deutschland GmbH & Co. KG**
**10553 Berlin (DE)**

(72) Inventors:
- **Cho, Wonjin**
**10553 Berlin (DE)**
- **Michalik, Fabian**
**10553 Berlin (DE)**
- **Lin, Cedric**
**10553 Berlin (DE)**
- **Han, Sandro**
**10553 Berlin (DE)**
- **Xiao, Ting**
**10553 Berlin (DE)**

(74) Representative: **Atotech Deutschland GmbH & Co. KG**
**Intellectual Property**
**Erasmusstraße 20**
**10553 Berlin (DE)**

# (54) METHOD FOR NANO ETCHING OF COPPER AND COPPER ALLOY SURFACES

(57) Method for nano etching of copper or copper alloy surfaces characterized by the following method steps:
i) providing a substrate having at least one copper or copper alloy surface,
ii) contacting at least a portion of said copper or copper alloy surface with a predip composition,
iii) contacting at least a portion of said copper or copper alloy surface with an etching solution,
characterized in that
- the steps are performed subsequently;
- step ii) is a non-etching step;
- step iii) is an etching step; and
- the predip composition comprises at least one sulfur-containing compound selected from a list defined in the claims.

Figure 5:

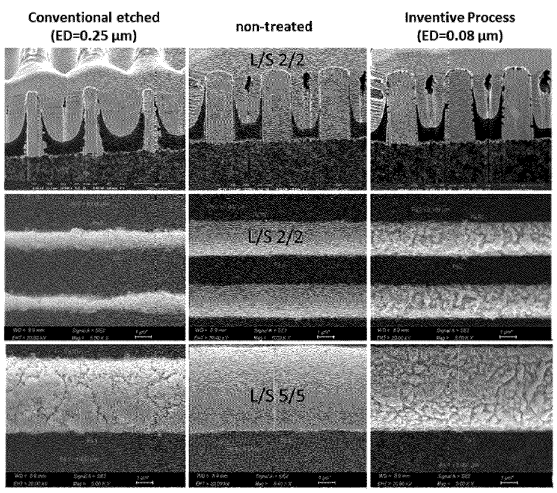


EP 4 279 634 A1

## Description

### Field of the Invention

The present invention relates to a method for nano etching of copper and copper alloy surfaces. Particularly, it relates to a method for nano etching of copper and copper alloy surfaces which is useful in the field of electronics industry for producing printed circuit boards, IC substrates, interposers, etc.

### Background of the Invention

In the production of printed circuit boards, the surface of copper is treated to promote the adhesion between the copper surface and a resist before coating the copper surface with photoresists, solder resists, resin for permanent adhesion, etc. In the treatment of substrates carrying fine wiring pattern, the chemical etching is usually used. In the production of multi-layered printed circuit boards, it has been attempted to promote the adhesion between a copper electroconductive patterned layer and a resin layer, for example, by forming an oxide layer on the copper surface and reducing the oxide layer to metallic copper by a reducing agent while maintaining the geometric shape of the oxide layer.

A negative pattern of the circuit is formed by a) applying an etch resist, e.g., a polymeric dry film resist or a metal resist on a layer of copper, b) etching away those portions of copper not covered by the etch resist, and c) removing the etch resist from the remaining copper circuit.

Etching solutions applied for this task are selected from different types of compositions such as mixtures of an oxidising agent and an acid. Two main types of etching solutions are based on an acid such as sulphuric acid or hydrochloric acid and contain as oxidising agent hydrogen peroxide, copper ions or ferric ions. Such etching solutions are disclosed in C. F. Coombs, Jr., "Printed Circuits Handbook", 5th Ed. 2001, Chapter 33.4.3, pages 33.14 to 33.15 and Chapter 33.4.5, pages 33.17.

The ongoing miniaturization of circuits in terms of line width / interline-space values and thickness of the copper layers to be etched does not allow using conventional etching solutions such as the ones described above.

EP 2 241 653 discloses compositions for micro etching of copper or copper alloys during manufacture of printed circuit boards. The composition comprises a copper salt, a source of halide ions, a buffer system and a benzothiazole compound as an etch refiner.

EP 2 754 732 discloses an aqueous composition for and a process for etching copper and copper alloys applying said aqueous composition. The aqueous composition comprises a source for $Fe^{3+}$ ions, an acid, a triazole or tetrazole derivative, and an etching additive selected from N-alkylated iminodipropionic acid, salts thereof, modified polyglycol ethers and quaternary ureylene polymers.

WO 2017/108513 discloses an aqueous etching solution and a method for treating a copper or copper alloy surface. The aqueous solution comprises at least one acid, at least one oxidising agent suitable to oxidize copper, at least one source of halide ions and comprising at least one polyamide.

EP 3 034 654 discloses a composition for micro etching of a copper or a copper alloy surface, wherein the composition comprises a source of $Fe^{3+}$ ions, a source of $Br^{-}$ ions, an inorganic acid, and a benzothiazole compound as an etch refiner.

WO 02/04706 discloses etching solutions which are acidic and contain hydrogen peroxide, at least one five-membered nitrogen containing heterocyclic compound and additionally at least one microstructure modifying agent which is selected from the group comprising organic thiols, organic sulfides, organic disulfides and thioamides.

The disadvantage of known etching methods is even more present if the copper tracks are manufactured by a semi additive process (SAP, Fig. 1A). Here, the bare dielectric substrate is first coated with a seed layer serving as an electrically conductive layer. The seed layer comprises for example copper deposited by electroless plating. Next, a patterned resist layer is formed on the seed layer and a thicker, second copper layer is deposited by electroplating into the openings of the patterned resist layer onto the seed layer. The patterned resist layer is stripped and the seed layer in between copper tracks deposited by electroplating needs to be removed by a differential etch step. The seed layer deposited by electroless plating has a finer grain structure than the second copper layer deposited by electroplating. The different grain structures can lead to a different etching behaviour of the individual copper layers.

A similar situation is present when copper tracks are manufactured by a modified semi additive process (m-SAP) or advanced modified SAP (am-SAP) wherein a thick, second copper layer is deposited in the openings of the patterned resist layer onto a first thin layer of copper. The first copper layer is manufactured, e.g. by thinning a copper clad attached to the dielectric substrate. Again, both first and second copper layer have a different grain structure.

Etching solutions based on sulphuric acid and hydrogen peroxide lead to an undesired undercutting of the first copper layer during etching (Fig. 1B) which results in an insufficient adhesion of the copper layer on the dielectric substrate.

Etching solutions based on sulphuric acid and ferric ions typically show an etching behaviour as shown in Fig. 1C. This trapezoidal line shape is undesired because the broader base of the etched copper line can lead to circuit

shorts which are not acceptable. This phenomenon of forming trapezoid etching results is referred to herein as "line shape alteration".

A further undesired side effect of copper etching is the reduction of line width in general. This is typically caused by too strong etching dissolving copper ions from all surfaces of the treated copper lines (see Fig. 1D).

## Objective of the present Invention

It is therefore the objective of the present invention to provide a method for nano etching of copper and copper alloys overcoming the restrictions and disadvantages of the prior art. It is also an objective of the present invention to provide a method for etching of copper and copper alloys resulting in an improved retention of the geometrical structures of copper or copper alloy lines after treatment such as rectangular line shape (measurable by the top-bottom-difference), a less pronounced line width reduction and avoidance of undercuts.

It is an objective of the present invention to provide a process to enhance adhesion between copper and dielectric material, while still maintaining the ultra-low roughness of copper surface.

As a particular objective, the adhesion performance expressed as a minimized drop in peel strength after Highly Accelerated Stress Test (HAST) shall be achieved.

It is an objective of the present invention to reduce signal loss in high frequency product application.

## Summary of the Invention

Above-mentioned objectives are solved by the etching method for copper and copper alloy surfaces according to claim 1. Preferred embodiments of the present invention can be found in the dependent claims.

## Description of the Figures

Figure 1 shows cross sections of various copper lines depicting

a) an untreated copper line (Fig. 1A);
b) a copper line with an undercut formation (Fig. 1B);
c) a copper line with a line shape alteration (Fig. 1C); and
d) a copper line with a line width reduction (Fig. 1D).

In Figure 1B, the copper line is labelled with 1 and the undercut with 2. The undercut can be seen to be present below the copper line. Figure 1C depicts a copper line with an undesired line shape alteration. The shown copper line has a trapezoidal shape and the dashed line highlights the desired rectangular shape. Figure 1D shows the untreated copper line of Figure 1A (above) and a treated copper line below and the line width reduction is stressed by the dashed line.

Figure 2 shows SEM images of different samples.

Figure 3 shows FE-SEM surface morphology of predip composition and etching solution (ED=0.08 μm) treated copper surface.

Figure 4 shows the surface roughness of (a) non-treated and (b) inventive method treated copper surface. The summary of measured Sa, Sq, St and RSAI are shown on left graph. The measurement was obtained by atomic force microscopy (AFM) with 20x20 μm measuring window.

Figure 5 shows the zero-line width reduction of inventive method treated circuitized conductor. No substantial change of line width after treatment.

Figure 6 shows copper removal mechanics in (a) inventive method with ED = 0.08 μm and (b) conventional adhesion enhancement with ED = 0.25 μm processes.

Figure 7 shows adhesion performance evaluation as peel strength has been conducted on different dielectric materials. Besides initial stage, peel strength was also performed at post-HAST stage. Material 1 is Ajinomoto GXT31 and New Material 2 is Ajinomoto GYXX. Further details are given in the Experimental Part.

Figure 8 shows adhesion performance evaluation as peel strength has been conducted at different stages of inventive method. Material 1 (Ajinomoto GXT31) was used in evaluation. Further details are given in the Experimental Part.

Figure 9 Signal integrity loss performance of inventive method surface @ 28 GHz in comparison with untreated and standard low roughening oxide replacement (OR) surfaces. High performance with low Dk dielectric material was laminated on circuitized copper.

## Detailed Description of the Invention

Percentages throughout this specification are weight-percentages (wt.-%) unless stated otherwise. One exception are yields which are given as percentage of the theoretical yield. Concentrations given in this specification refer to the volume of the entire solutions unless stated otherwise.

The method for nano etching of copper or copper alloy surfaces is characterized by the following method steps:

i) providing a substrate having at least one copper or copper alloy surface,
ii) contacting at least a portion of said copper or copper alloy surface with a predip composition,
iii) contacting at least a portion of said copper or copper alloy surface with an etching solution,

characterized in that

- the steps are performed subsequently;
- step ii) is a non-etching step;
- step iii) is an etching step; and
- the predip composition comprises at least one sulfur-containing compound selected from the group consisting of

a) compounds of formula (I)

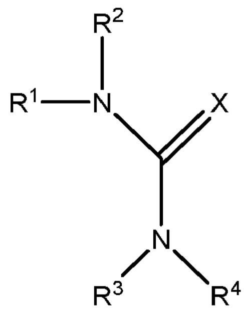

(I),

wherein

X = S or S(O);
$R^1$, $R^2$, $R^3$, $R^4$ = H, C1-C6-alkyl, OH,
preferred thiourea [X = S; $R^1$, $R^2$, $R^3$, $R^4$ = H],
derivates, salts and mixtures thereof;

b) compounds of formula (II)

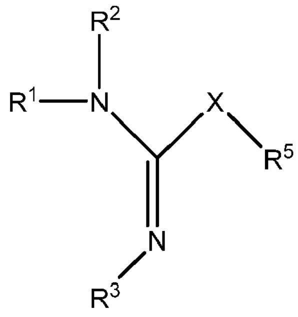

(II)

wherein

X = S, S(O), S-S;
$R^1$, $R^2$, $R^3$ = H, C1-C6-alkyl, OH or $R^1$+$R^3$ = CH=CH,
$R^5$ = H, C1-C6-alkyl, OH,

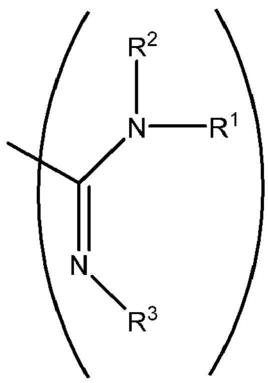

,

or $R^3$+$R^5$ = CH=CH,
derivates, salts and mixtures thereof;

c) compounds of the structure Y-H or $Y_2$ (thiols or disulfides) with Y- =

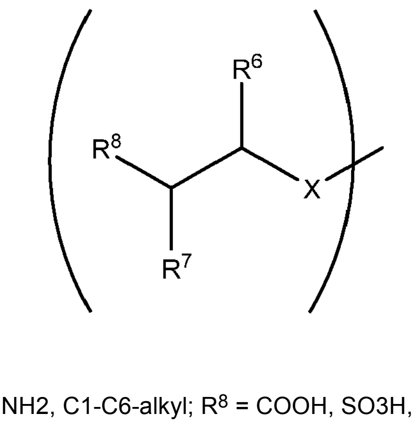

wherein X = S,
$R^6$ = COOH, C1-C6 alkyl; $R^7$ = H, NH2, C1-C6-alkyl; $R^8$ = COOH, SO3H, C1-C3-alkyl; and
d) 3-nitrobenzene sulfonic acid.

The steps are carried out in the order given above.

Step i) - Providing a substrate having at least one copper or copper alloy surface

Substrates in the context of the present invention can be any substrate comprising a copper and copper alloy surface. Substrates can be made of copper or copper alloys in their entirety or alternatively, they comprise surfaces made of copper or copper alloys. Preferably, substrates are selected from copper foils, copper alloy foils, printed circuit boards, IC substrates, interposers, copperised semiconductor wafers and copper clad laminates (CCL). Copperised semiconductor wafers means wafer substrates with copper or copper alloy structures thereon such as trenches, lines, dots and so forth.

Copper surfaces are defined herein to be preferably made of 99 wt.-% or more of copper. The term "copper alloys" according to the present invention preferably refers to alloys consisting of 90 wt.-% to 99 wt.-% copper. Preferably, the further components of the alloy are selected from one or more of boron, silicon, phosphorous or another metal such as nickel, iron, cadmium, zinc, tin, titanium.

Particular preference is given to electrolytically deposited (ED) copper and copper alloys surfaces, more preferably those having average grain sizes dso of 1 to 5 μm as determined by SEM (scanning electron microscopy).

Step ii) - Contacting at least a portion of said copper or copper alloy surface with a predip composition

The method for treating a copper or copper alloy surface according to the invention comprises the step ii). This step ii) is performed between steps i) and iii).

From the prior art, e.g. WO 2017/108513, it is known that etching processes can optionally comprise a so-called pre-treatment step of the copper or copper alloy surface: the pre-treatment is performed between steps i) and iii). Pre-treatment methods of copper and copper alloy surfaces are known in the art. Such pretreatment includes *inter alia* cleaning steps, removal of undesired layers such as chromate and/or oxide layers, and the deposition of organic monolayers (e.g. monolayers of azole corrosion inhibitors, leveller or brightener compounds which are typically used in electrolytic copper plating).

Cleaning of copper and copper alloy surfaces can be accomplished by various means known in the art. Typically, such cleaning steps use aqueous solutions which may be acidic or alkaline which optionally comprise surfactants and/or co-solvents such as glycols. Chromate layers can be removed by oxidative treatments employing for example aqueous solutions containing sodium persulphate and/or other oxidising agents. Oxide layers or other undesired residuals on the copper or copper alloy surface can be removed by acidic aqueous treatments. Organic monolayers can be formed by treating copper or copper alloy surfaces with aqueous solutions comprising azole corrosion inhibitors such as benzotriazole.

In contrast, in the method of the instant invention step ii) the predip composition comprises at least one sulfur-containing compound selected from the group consisting of several subgroups a) to d).

These subgroups a) to d) are specified below.

The term "alkyl group" according to the present invention comprises branched or unbranched alkyl groups comprising cyclic and/or non-cyclic structural elements, wherein cyclic structural elements of the alkyl groups naturally require at least 3 carbon atoms. The term "C1-CX-alkyl group" according to the present invention refers to alkyl groups having 1 to X carbon atoms. C1-C6-alkyl for example includes, among others, methyl, ethyl, n-propyl, *iso*-propyl, n-butyl, *iso*-butyl, sec-butyl, *tert-butyl,* n-pentyl, iso-pentyl, sec-pentyl, *tert*-pentyl, neo-pentyl and hexyl. Substituted alkyl groups may theoretically be obtained by replacing at least one hydrogen by a functional group like an amino, hydroxyl, thiol, alkoxyl and thioalkyl. Preferably, alkyl groups are not substituted or they are substituted by hydroxyl and/or amino groups.

In so far as the term "aryl" is used in this description and in the claims, it refers to ring-shaped aromatic hydrocarbon residue, for example phenyl or naphtyl, where individual ring carbon atoms can be replaced by N, O and/or S, for example benzothiazolyl. Furthermore, aryl residues can be substituted by replacing a hydrogen in each case by a functional group, for example amino, hydroxyl, thiol, alkoxyl and thioalkyl. Preferably, aryl groups are not substituted or they are substituted by hydroxyl and/or amino groups

In so far as the term "aralkyl" is used in this description and in the claims, it refers to a hydrocarbon residue consisting of an alkyl and an aryl group such as benzyl and tolyl.

*a) Compounds of formula (I)*

Compounds of formula (I)

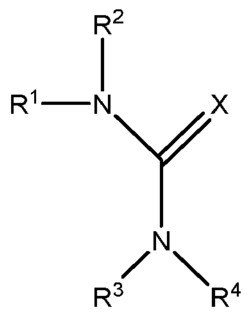

(I),

wherein

X = S or S(O);
$R^1$, $R^2$, $R^3$, $R^4$ = H, C1-C6-alkyl, OH,
derivates, salts and mixtures thereof;

*b) Compounds of formula (II)*

Compounds of formula (II)

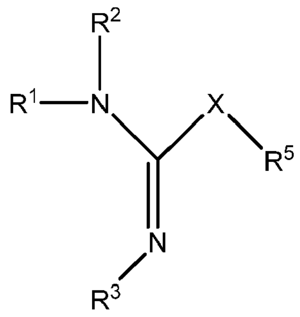

(II)

wherein

X = S, S(O), S-S;

$R^1$, $R^2$, $R^3$ = H, C1-C6-alkyl, OH or $R^1$+$R^3$ = CH=CH,

$R^5$ = H, C1-C6-alkyl, OH or $R^3$+$R^5$ = CH=CH,

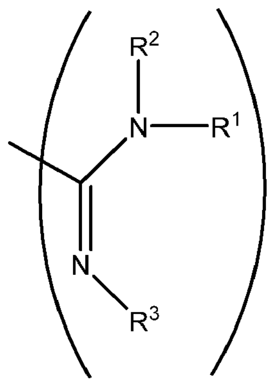

,

derivates, salts and mixtures thereof;

Formulas (I) and (II) comprise the same structural element of Formula (III):

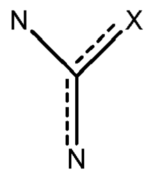

(III)

The dotted lines in Formula (III) represent that one of the respective bonds is a double bond whereas the other bond is a single bond.

Further substituents at the N atoms and, potentially, the X group are not depicted.

This leads to two possible structural elements: one in which the double bond is between the carbon atom and the S atom of group X; at the same time the bond between the carbon atom and the second N atom is a single bond. This structural element is represented by formula (IV):

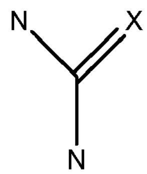

(IV)

The other possible structural element is one in which the double bond is between the carbon atom and the second N atom; at the same time the bond between the carbon atom and the S atom of group X is a single bond. This requires that X bears at least one further substituent which is also not depicted. This structural element is represented by formula (V):

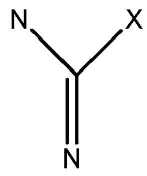

(V)

*c) compounds of the structure Y-H or $Y_2$ (thiols or disulfides)*

with Y- =

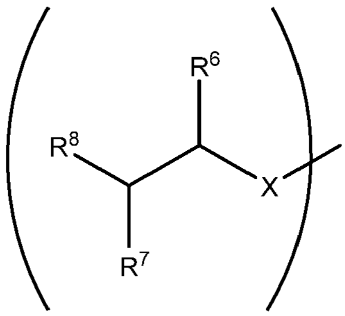

wherein X = S
$R^6$ = COOH, C1-C6 alkyl; $R^7$ = H, NH2, C1-C6-alkyl; $R^8$ = COOH, SO3H, C1-C3-alkyl
derivates, salts and mixtures thereof;

*d) 3-Nitrobenzene sulfonic acid*

3-Nitrobenzene sulfonic acid.
Step ii) is a non-etching step.
This means that no considerable weight loss on the copper or copper alloy could be detected during step ii).
The weight loss is determined as follows. The "dry" panel is weight before and after treatment. For a standard 15 cm x7.5 cm board, where both sides contain Copper, a weight difference of 10 mg is related to 50 nm etch depth. 'No considerable weight loss' means that the weight loss of the panel is 2 mg per panel or less, preferably 1 mg per panel or less.
The pH value of the predip composition according to the invention preferably is of from -1 to 11.
For pH below 7, the pH is adjusted with at least one acid selected from inorganic and/or organic acids. Preferred acids are gluconic acid, sulfuric acid, formic acid, propionic acid and methanesulfonic acid (MSA).
For pH above 7, the pH is adjusted with at least one base selected from alkaline. Preferred is inorganic alkali (KOH, NaOH). Most preferred is NaOH.
In the method of the instant invention step ii) the predip composition comprises at least one sulfur-containing compound selected from the group consisting of several subgroups a) to d). The total concentration of above-named sulfur-containing compound selected from the group consisting of several subgroups a) to d) preferably ranges from 20 mg/l to 20 g/l, more preferably ranges from 50 mg/l to 10 g/l and even more preferably ranges from 100 mg/l to 1 g/l.
The temperature of the predip composition in step ii) preferably ranges from 20 to 70 °C, more preferably from 20 to 55 °C, even more preferably from 30 to 55 °C.
The time of contact of the predip composition and the copper or copper alloy surface has to be adjusted to the temperature of the predip composition. The time of contact of the predip composition and the copper or copper alloy surface ranges typically from 15 to 600 seconds, more preferably it ranges from 15 to 300 s, even more preferably it ranges from 30 to 90s.

<u>Step iii) - Contacting at least a portion of said copper or copper alloy surface with an etching solution</u>

Step iii) is an-etching step.

This means that, by weight loss measurement, considerable differences of copper and copper alloy can be detected prior to/after step iii). The weight loss is determined as described before. 'Considerable weight loss' means that the weight loss of the panel is 1 mg per panel or more, preferably 5 mg per panel or more.

Etching solution

The etching solution comprises at least one oxidising agent suitable to oxidise copper. Oxidising agents suitable to oxidise copper typically have a standard oxidation potential greater than copper for a given concentration and pH value. Typically, the concentration of the at least one oxidising agent suitable to oxidise copper ranges from 0.05 to 20 wt.-%, preferably from 1.0 to 10.0 wt.-% or 15 wt.-%.

Preferably, the at least one oxidising agent is selected from the group consisting of peroxides such as hydrogen peroxide, metal peroxides like sodium peroxide, potassium peroxide; metal superoxides such as potassium superoxide; copper ions and ferric ions. To prevent decomposition of peroxides, other additional compounds such as p-phenolsulphonic acid can be added. Peroxides and superoxides are preferably contained in a concentration ranging from 1 to 150 g/l.

Ferric ions can be provided by any water-soluble source of ferric ions such as iron (III) salts (*i.e.* ferric salts) or iron (III) complexes. Preferably, the source of ferric ions is selected from the group consisting of ferric sulphate ($Fe_2(SO_4)_3$), ferric chloride ($FeCl_3$), ferric bromide ($FeBr_3$), ferric nitrate ($Fe(NO_3)_3$), ferric acetate ($Fe(OC(O)CH_3)_3$), ferric hydroxide ($Fe(OH)_3$), the respective hydrates thereof or mixtures of the aforementioned. Ferric ions are preferably contained in a concentration ranging from 1 to 50 g/l.

Copper ions can be provided by any water-soluble source of copper ions such as copper salts or copper complexes. Any water-soluble copper salt is a possible source of copper ions, preferable sources of copper ions are copper (II) sulphate, copper (II) chloride, copper (II) bromide, copper (II) acetate, copper (II) formiate, copper (II) oxide, copper (II) hydroxide, copper (II) alkylsulphonate, copper (II) arylsulphonate, hydrates thereof or mixtures of the aforementioned. Copper ions are preferably contained in a concentration ranging from 1 to 70 g/l.

The at least one oxidising agent can be selected from the group consisting of copper ions and ferric ions. The etching solution can comprise at least one source of ferric ions and at least one source of copper ions as oxidising agents.

The etching solution comprises at least one acid. Said at least one acid is preferably selected from the group consisting of sulphuric acid, alkyl sulphonic acids such as methane sulphonic acid, aryl sulphonic acids such as phenylsulphonic acid, toluenesulphonic acid, nitric acid, phosphoric acid, formic acid, acetic acid, propionic acid and mixtures thereof. Sulphuric acid, alkyl sulphonic acids and aryl sulphonic acids are more preferred because of their high conductivity rendering them extremely useful where the etching solution is to be regenerated by electrolytic means. The total concentration of above-named acids preferably ranges from 10 to 250 g/L.

The etching solution optionally comprises at least one source of halide ions. Sources of chloride ions and sources of bromide ions are preferred. Fluoride ions may form hydrofluoric acid in acidic media which is very toxic and difficult to handle whereas iodic ions may be oxidised in the etching solution rendering them ineffective. Examples of suitable sources of chloride ions are water-soluble chloride salts. Preferably, the at least one source of chloride ions is selected from the group consisting of hydrogen chloride, water soluble metal chlorides such as alkali chlorides like lithium chloride, sodium chloride, potassium chloride and caesium chloride, earth alkaline chlorides like manganese chloride, calcium chloride, strontium chloride and barium chloride, transition metal chlorides like manganese chloride, iron chloride, cobalt chloride, nickel chloride, copper chloride and zinc chloride, ammonium chloride and mixtures thereof. More preferably, the at least one source of chloride ions is selected from the group consisting of hydrogen chloride, alkali chlorides and ammonium chloride. Examples of suitable sources of bromide ions are water-soluble bromide salts. Preferably, the at least one source of bromide ions is selected from the group consisting of hydrogen bromide, water soluble metal bromides such as alkali bromides like lithium bromide, sodium bromide, potassium bromide and caesium bromide, earth alkaline bromides like manganese bromide, calcium bromide, strontium bromide and barium bromide, transition metal bromides like manganese bromide, iron bromide, cobalt bromide, nickel bromide, copper bromide and zinc bromide, ammonium bromide and mixtures thereof. More preferably, the at least one source of bromide ions is selected from the group consisting of hydrogen bromide, alkali bromides, ammonium bromide and zinc bromide. In a preferred embodiment of the invention, the concentration of halide ions is 1 mg/l or higher. In a more preferred embodiment of the invention, the concentration of halide ions is 5 mg/l or higher. The concentration of all halide ions preferably ranges from 1 to 500 mg/l, more preferably from 10 to 200 mg/l and most preferably from 20 to 100 mg/l if ferric ions are used as sole oxidising agent. The concentration of all halide ions preferably ranges from 1 to 50 mg/l, more preferably from 5 to 30 mg/l, if peroxides or superoxides are used as sole oxidising agent. The concentration of all halide ions preferably ranges from 0.1 to 200 g/l, more preferably from 1 to 100 g/l, if copper ions are used as sole oxidising agent. Ferric halides or copper halides as oxidising agents may also provide the optional halide ions. Halide ions improve the etching results insofar that undesired etching of very thin copper lines such as those of less than 10 $\mu$m in width can be prevented and the line shape alteration is less pronounced.

The etching solution optionally comprises at least one azole corrosion inhibitor selected from the group consisting

of benzotriazole, 5-methylbenzotriazole, 1*H*-1,2,3-methylbenzotriazole, imidazole, 1*H*-1,2,3-triazol, 4-methylthiazole, 3-amino-1*H*-1,2,4-triazole, 1*H*-tetrazole, 5-methyl-1*H*-tetrazole, 5-phenyl-1*H*-tetrazole and 5-amino-1*H*-tetrazole. Preferably, the azole corrosion inhibitor is selected from 1*H*-tetrazole, 5-methyl-1*H*-tetrazole, 5-phenyl-1*H*-tetrazole and 5-amino-1*H*-tetrazole as such tetrazole derivatives provide improved stability of the etching solution. The addition of azole corrosion inhibitors advantageously reduces the corrosion of the metal surfaces to be treated due to the formation of a protective azole layer and sometimes they also decrease the formation of precipitates from the etching solution during use. Occasionally, after some copper dissolution from the copper or copper alloy surface precipitates are formed which limit the life-time of the etching solution. The total concentration of the optional azole corrosion inhibitor preferably ranges from 0.01 to 2.0 wt.-% if the etching solution comprises at least one azole corrosion inhibitor.

The etching solution optionally comprises at least one polyalkylene glycol compound such as polyethylene glycol, polypropylene glycol, copolymers of polyethylene glycol and polypropylene glycol and derivatives thereof which all may improve the wettability of the copper or copper alloy surface to be treated and thus the etching behaviour of the etching solution according to the present invention. The total concentration of the optional polyalkylene compounds in the etching solution ranges from 100 to 2000 mg/l, if the etching solution comprises at least one polyalkylene compounds.

If the etching solution comprises iron(III) as oxidising agent it optionally additionally comprises at least one source of ferrous ions. Ferrous ions can be provided by any water-soluble source of ferrous ions such as iron (II) salts (*i.e.* ferrous salts) or iron (II) complexes. Preferably, the source of ferrous ions is selected from the group consisting of ferrous sulphate ($FeSO_4$), ammonium ferrous sulphate ($(NH_4)_2Fe(SO_4)_2$), ferrous chloride ($FeCl_2$), ferrous bromide ($FeBr_2$), ferrous nitrate ($Fe(NO_3)_2$), ferrous acetate ($Fe(OC(O)CH_3)_2$) and ferrous hydroxide ($Fe(OH)_2$) and the respective hydrates thereof. The optional ferrous ions are preferably used in a concentration ranging from 1 to 50 g/l. The use of the optional ferrous ions is particularly useful when ferric ions are used as oxidising agent and a regeneration of the etching solution is desired.

The etching solution according to the invention is an aqueous solution. This means that the prevailing solvent is water. Other solvents which are miscible with water such as polar solvents including alcohols, glycols and glycol ethers may be added. For its ecologically benign characteristics, it is preferred to use water only (*i.e.* more than 99 wt.-% based on all solvents).

The pH value of the etching solution according to the invention preferably is ≤ 11, more preferably ≤ 7, even more preferably ≤ 4, most preferably ≤ 1.5. Particularly preferred, the pH value of the etching solution according to the invention is ≤ 1.0.

The etching solution according to the invention can be prepared by dissolving all components in water. Should solubility issues arise pH adjustors such as acids and bases can be used to increase the solubility of the components to be dissolved. It can also be prepared by providing concentrates which are then diluted and/or mixed prior to use of the etching solution according to the invention.

In one embodiment of the present invention, the etching solution is an aqueous solution comprising or consisting of

a) at least one acid;
b) at least one oxidising agent suitable to oxidise copper;
c) optionally, at least one source of halide ions;
d) at least one solvent, preferably water;
e) optionally, at least one azole corrosion inhibitor;
f) optionally, at least one polyalkylene compounds; and
g) optionally, at least one source of ferrous ions

in above-defined concentrations for the individual components.

In a preferred embodiment of the present invention (referred to herein as "ferric ion etching solution"), the etching solution is an aqueous solution comprising or consisting of

a) at least one acid;
b) at least one sources of ferric ions, preferably in a concentration ranging from 1 to 50 g/l;
c) at least one source of halide ions;
d) at least one solvent, preferably water;
e) optionally, at least one azole corrosion inhibitor; and
f) optionally, at least one polyalkylene compounds.

In another preferred embodiment of the present invention (referred to herein as "copper ion etching solution"), the etching solution is an aqueous solution comprising or consisting of

a) at least one acid;
b) at least one sources of copper ions, preferably in a concentration ranging from 1 to 70 g/l;
c) at least one source of halide ions;
d) at least one solvent, preferably water;
e) optionally, at least one azole corrosion inhibitor; and
f) optionally, at least one polyalkylene compounds.

In another preferred embodiment of the present invention, the etching solution is an aqueous solution comprising or consisting of

a) at least one acid;
b) at least one oxidising agent selected from the group consisting of peroxides and superoxides;
c) optionally, at least one source of halide ions;
d) at least one solvent, preferably water;
e) optionally, at least one azole corrosion inhibitor; and
f) optionally, at least one polyalkylene compounds

in above-defined concentrations for the individual components.

An etching solution comprising peroxide or superoxide as oxidising agent is *inter alia* useful for roughening of copper or copper alloy surfaces. Complete removal of seed layers even in areas with high conductor density is possible with the etching solution according to the invention.

According to the invention, the etching solution can be used for etching of copper and copper alloy surfaces, thus allowing for subsequently tightly bound organic matrices or final finishes such as immersion tin to the copper or copper alloy surface or to the organic matrix bound thereon while avoiding substantial line shape alteration, undercuts and line width reductions. Sufficient adhesion of organic matrices and final finishes can thus be provided.

Step iii) is herein also referred to as "treatment step". The contact of at least a portion of the copper or copper alloy surfaces with the etching solution can be affected by any means known in the art. Typically, the etching solution can be sprayed, wiped or otherwise brought onto the copper or copper alloy surface or the copper or copper alloy surface can be dipped or immersed into the etching solution. Preferably, the etching solution is sprayed on said surface. The transport of the etching solution to the surface is also improved and diffusion processes are minimised.

The etching solution can also be used in horizontal equipment, reel-to-reel, vertical and vertically conveyorized equipment.

The temperature of the etching solution in step iii) preferably ranges from 20 to 50 °C. Higher temperatures of the etching solution result in faster etching processes of the copper or copper alloy surface. However, too high temperatures may be detrimental to the stability of the etching solution.

The time of contact of the etching solution and the copper or copper alloy surface has to be adjusted to the temperature of the etching solution and the desired etch depth. The time of contact of the etching solution and the copper or copper alloy surface ranges typically from 5 to 300 seconds. In some cases it is necessary to adjust the time of contact to the desired etch result, e.g. if more copper is to be removed. This adjustment can be performed by routine experiments if necessary.

The method according to the invention may comprise rinsing steps with solvents such as water during the individual process steps. Particularly, after the contact of the copper or copper alloy surface with the etching solution, it is advisable to rinse the copper or copper alloy surface with water to remove any undesired remnants of the solution. The method according to the invention may further comprise drying steps. It is possible for example to rinse the copper or copper alloy surface with hot water after the treatment step followed by drying with hot air or in an oven. Then, the copper or copper alloy surfaces may be immersed or treated otherwise with a dilute acid solution (e.g. 10 wt.-% hydrochloric acid or 10 wt.-% sulphuric acid) prior to any further processing.

<u>Further steps (optional)</u>

The method for treating a copper or copper alloy surface according to the invention optionally further comprises the following step
iv) contacting the copper or copper alloy surface with a post-dip solution.

This step is referred to as "post-dip step".

Optional step iv) (post-dip step) is included in the method for treating a copper or copper alloy surface according to the invention after step iii) (treatment step). The contacting of the copper or copper alloy surface and the post-dip is selected from the same possibilities as given for the contact between the etching solution and the copper or copper alloy surface in step iii). The same or a different contact possibility may be chosen. If a post-dip step was performed, it is

advantageous to rinse the copper or copper alloy surface thoroughly or to remove any residues therefrom otherwise prior to photoresist or solder-mask applications.

A variety of post-dip solutions can be used. In the following, several classes are described. The respective designations describe the main characteristic. However, combinations of these characteristics are possible.

The acidic post-dip solution is an aqueous solution containing at least one acid, preferably hydrochloric acid. The pH value of the acidic post-dip is typically 1 or less. The acidic post-dip is typically used if copper chloride was used as oxidising agent in the etching solution. Alternatively, an acidic post-dip may be used if a photo-resist is applied subsequently or at a later stage of the method according to the invention because photo-resists are labile to alkaline treatments or such alkaline remnants present on a surface whereon such a photo-resist is to be deposited.

The alkaline post-dip solution is an aqueous solution containing at least one source of hydroxide ions ($OH^-$). Such sources of hydroxide ions can be any water-soluble compounds which upon contact with water liberate or form otherwise hydroxide ions such as bases. Preferably, sources of hydroxide ions are selected from metal hydroxides such as alkali hydroxides and amines such as ammonia. The pH value of the alkaline post-dip solution is typically 10 or higher. The alkaline post-dip solution is optionally used if a solder mask is to be applied subsequently or at any later stage because solder masks are labile to acidic treatments, acidic remnants on a surface whereon such a solder mask is to be deposited or if oxidising agents other than copper ions are present in the etching solution.

The organic post-dip solution comprises at least one organic molecule such as the ones disclosed in EP2020/055192, and/or EP2019/061526 which are hereby incorporated by reference. It has been found that the organic post-dip solution can have a number of advantages such as anitarnish effect, boosting adhesion to resin materials (e,g. for permanent adhesion or for solder resist) and/or increasing darkening effect.

The method for treating a copper or copper alloy surface according to the invention optionally further comprises the following step

v) laminating an organic matrix onto the treated copper or copper alloy surface.

Organic matrices include but are not limited to prepregs, epoxy resin curing agent, solder masks, photo-resists and the like. Prepregs are fibre-reinforced plastics, typically glass-reinforced epoxy-matrices are used such as FR-4, FR-5 and sequential build-up films (e.g. Ajinomoto GX92, Ajinomoto GXT31).

Alternatively or further to step v) it is possible to include step

vi) deposition of a final finish on the treated copper or copper alloy surfaces or portions thereof into the method according to the invention.

Said final finishes include such finishes as immersion tin, electroless nickel immersion gold (ENIG), electroless nickel electroless palladium electroless gold (ENEPIG), electroless palladium electroless gold (EPIG), immersion silver, organic solder preservatives (OSP) and the like. These finishes are well-established in the art. Useful tin deposition methods e.g. include immersion tin plating as described in EP 2476779 B1.

Advantageously, the method according to the invention results in little or no line shape deterioration due to little or no copper dissolution from the sides of copper trenches and lines.

Different objectives and their achievements by the inventive method are described hereafter.

*Surface morphology*

The method according to the invention produces cavities in the copper or copper alloy surfaces, wherein a plurality of the cavities is obtuse with respect to the top surface, and a plurality of the cavities are at least 50 nm and less than 500 nm deep.

The morphology of different copper surfaces was observed with FE-SEM after step ii) and step iii) of the inventive method. The results are shown in Figure 3.

After step ii), the DC copper surface shows an extremely smooth surface profile with a visible polycrystalline copper grain size. An island of different crystal grain sizes is distributed uniformly along the surface (Figure 3, top left).

A similar surface profile is observed on a circuitized sample (Figure 3, bottom left).

After step iii), cavities with shallow depth generated from copper removal act by etching chemistry. The copper removal in z direction (trench etching) followed the island boundary of copper grains which has been detected previously in predip treated surface. As an indication of preferred side of copper removal by etching is at grain boundaries. State of the art, grain boundary of copper can act as sinks and transport pathways for site defects by corrosive chemistry. This is likely the valid phenomenon that occur to copper surface in etching chemistry. Thus, morphology comprise of cavities in nano size is obtained on copper surface subsequently treated with the etching solution.

*Ultra low roughness*

A main objective of inventive method process was to enhance adhesion between copper and dielectric material, while still maintaining the ultra-low roughness of copper surface. Couple of roughness measurements have been conducted to measure the surface roughness increase by inventive method treatment. Atomic force microscopy (AFM) was used as the chosen method, due to its higher resolution in measuring surface roughness in nano scale. It is noticeable in Figure 4 that Sa, Sq and St measured in AFM of copper surface have shown only minor increase by inventive method treatment, in comparison to non-treated surface.

The respective measures are:

Sa : mean surface roughness;

Sq : root mean square roughness

St : peak-peak

RSAI : Relative Surface Area Increase.

In contrast, the measured relative surface area increase (RSAI %) of surface treated with inventive method have shown major increased up to 40 % higher than non-treated surface.

The method of the instant invention creates a surface which exhibits a nanostructure rather than a microstructure. Hence, the wanted ultra-low roughness of copper surface is achieved by the inventive method.

In the method of instant invention, the substrate comprising a copper or copper alloy surface is preferably selected from copper foils, copper alloy foils, printed circuit boards, IC substrates, interposers, copperised semiconductor wafers and copper clad laminates.

In a preferred embodiment, a method for producing cavities in the copper or copper alloy surfaces is provided.

In a more preferred embodiment, a plurality of the cavities is obtuse with respect to the top surface.

In another more preferred embodiment, a plurality of the cavities are at least 50 nm and less than 500 nm deep.

Preferred the article with a copper or copper alloy surface is a patterned sample.

In the method of the instant invention, the change of dimension of the pattern is smaller than 10% of the original value, preferred the change of dimension of the pattern is smaller than 7% of the original value, more preferred the change of dimension of the pattern is smaller than 5% of the original value, most preferred the dimension of the pattern is not changed.

In a particular embodiment, the change of dimension is line width reduction.

Hence, in a preferred method of the instant invention, the line width reduction is smaller than 10% of the original value, preferred the line width reduction is smaller than 7% of the original value, more preferred the line width reduction is smaller than 5% of the original value, most preferred the line width reduction is 0% of the original value.

As shown in Figure 5, the dimensions (L/S) of all circuitized copper have no substantial changed from non-treated stage. In comparison, on the left part of Figure 5 we can clearly see the substantial reduction in line width when the conventional adhesion enhancement process is used. The reduction is even more exacerbated when smaller dimensions are treated in this process.

Without wanting to be bound by any particular theory or explanation, the following is assumed:

In order to explain above mentioned phenomenon, one must first understand the difference between processes, in respect of the mechanics of how the copper is removed from the surface (Figure 6). The key to the etching technique of copper was the use of oxidizing agents (strong oxidizer), dissolving agents (acid and or solvent) and etching additives. An optimum combination of those components will determine the rate of copper removal and preferred reaction site on the surface simultaneously. Elementary chemical composition of conventional etching process is usually designed to react with the copper surface in all sites, not being selective in removal (Figure 6b). Besides striking copper grain boundary as weak point, the chemistry is also charging on copper grain. Etch down recession of the underlying copper layer enhanced. Thus, excessive line width reduction is inevitable. In contrary to conventional etching process, step (iii) in the inventive method is hindering the striking of copper grain. It preferentially dissolves the dislocation sites in the grain boundary. Therefore, formation of roughness on surface without line width reduction is achievable.

*Adhesion performance*

Adhesion performance between copper and dielectric material was evaluated by peel strength test. The unit of measurement is N/cm. Despite of its ultra-low roughness character, inventive method treated copper foils shows an outstanding good adhesion performance on different dielectric materials (Figure 7).

Just after lamination (Initial) of peel strength of inventive method treated sample is similar to non-treated one. This is valid for both dielectric materials. Peel strength is around 8 N/cm and 6 N/cm for Material 1 (Ajinomoto GXT31) and New Material 2 (Ajinomoto GYXX), respectively. A distinct difference in peel strength forces suggests variation in material properties. In Highly Accelerated Stress Test (HAST) test, specimen suffers from water moisture penetration at the interface of copper/dielectric material. The degradation of the peel strength after is mainly induced by the water molecules in the humid oven chamber. At weak interfacial bond of copper/dielectric material, penetrated water molecules substitute the bonding, because of the higher interaction energy of water with the copper surface. This can be seen in Figure 7 for non-treated surface, where peel strength post-HAST is deteriorated significantly, from 7.8 N/cm (initial) to 3.1 N/cm (post-HAST) and from 6 N/cm (initial) to 2.9 N/cm (post-HAST) for Material 1 and New Material 2 respectively.

The incorporated inventive method specimen could withstand HAST test with only marginal drop in peel strength after the test thanks to the mechanical anchoring from nano structure generated in step iii) of the inventive method and the chemical bonding from pre-coating and coating. A strong interfacial bond of copper/dielectric material hinders the detrimental effect of water molecules penetration at interface.

To make distinction of different contribution of mechanism to the adhesion enhancement, set of specimens were prepared for peel strength test. To minimize data interpretation concerns, only Material 1 was used in evaluation. Copper foils were laminated with dielectric material in each sequential step of inventive method process, and initial and post-HAST peel strength data are shown in Figure 8. Similar to previously observed peel strength data, no distinct difference among tested specimens of just after lamination (initial). Post-HAST peel strength, predip treated only specimen has the strongest drop. This means that if the method is performed with steps i) and ii) but without step iii), the drop is most significant. In contrast, if the method is performed according to the invention, i.e. comprising all steps i) to iii), the post-HAST peel strength is improved by 40 %. This suggests that nano structure formation on the surface in step iii) has an essential contribution to the adhesion enhancement. Nonetheless, when the specimen was subsequently treated with pre-coating and coating, i.e. additionally comprising a step iv) wherein the post-dip solution is a organic post-dip solution, the peel strength increases further by 67 %.

*Low signal loss of inventive method*

As one of the main objectives of ultra-low roughness adhesion enhancement system is to reduce signal loss in high frequency product application. Hence, further test was made to measure the signal insertion loss at high frequency bandwidth. In this occasion the frequency that has been applied in the test was 28 GHz. A low Df dielectric material and inventive method treated copper were used for creating specimen of build-up assembly. At the same time, additional specimens of non-treated copper and low roughness oxide replacement (OR) were also included for benchmarking the performance (Figure 9).

The ultra-low roughness property of inventive method has an obvious advantage on the insertion loss performance at high frequency. The insertion loss is much reduced in comparison to low roughness OR by almost 2 %. Thanks to the ultra-low roughness created by the process. The difference between inventive method and non-treated specimen is only marginal in degree. It shows the leverage of ultra-low roughness of inventive method for high-frequency substrate application.

## EMBODIMENTS

A. Method for nano etching of copper or copper alloy surfaces characterized by the following method steps:

i) providing a substrate having at least one copper or copper alloy surface,

ii) contacting at least a portion of said copper or copper alloy surface with a predip composition,

iii) contacting at least a portion of said copper or copper alloy surface with an etching solution,

characterized in that

- the steps are performed subsequently;
- step ii) is a non-etching step;
- step iii) is an etching step; and

- the predip composition comprises at least one sulfur-containing compound selected from the group consisting of

a) compounds of formula (I)

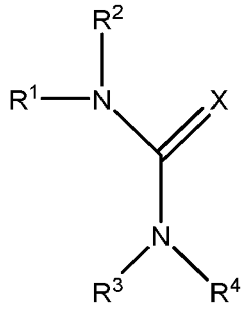

(I),

wherein

X = S or S(O);
$R^1$, $R^2$, $R^3$, $R^4$ = H, C1-C6-alkyl, OH,
derivates, salts and mixtures thereof;

b) compounds of formula (II)

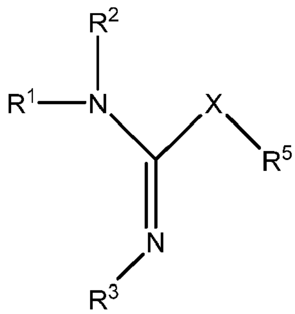

(II)

wherein

X = S, S(O), S-S;
$R^1$, $R^2$, $R^3$ = H, C1-C6-alkyl, OH or $R^1$+$R^3$ = CH=CH,
$R^5$ = H, C1-C6-alkyl, OH or $R^3$+$R^5$ = CH=CH

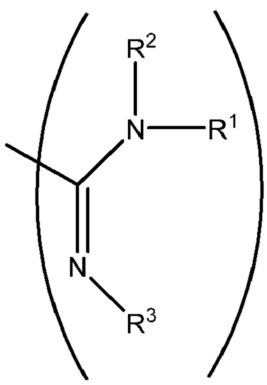

,

derivates, salts and mixtures thereof;

c) compounds of the structure Y-H or $Y_2$ (*thiols or disulfides*) with Y- =

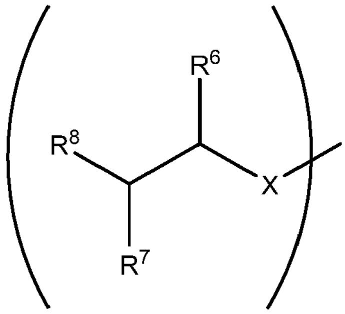

wherein X = S,

$R^6$ = COOH, C1-C6 alkyl; $R^7$ = H, NH2, C1-C6-alkyl; $R^8$ = COOH, SO3H, C1-C3-alkyl and

d) 3-nitrobenzene sulfonic acid.

B. Method of embodiment A, wherein the at least one sulfur-containing compound is selected from the group consisting of

a) thiourea [X = S; $R^1$, $R^2$, $R^3$, $R^4$ = H],

b) 2-aminothiazole [X = S, $R^1$, $R^2$= H, $R^3$+$R^5$ : -CH=CH-], 2-mer-captoimidazole [X = S, $R^2$, $R^5$ = H, $R^1$+$R^3$ : -CH=CH-], formamidine disulfide (dihydrochloride) (X = S-S, $R^1$, $R^2$, $R^3$ = H, $R^5$ =

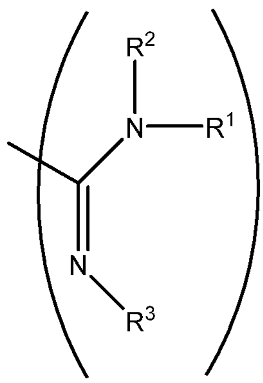

,

formamidine sulfinic acid [X = S(O), $R^1$, $R^2$, $R^3$ = H, $R^5$ = OH], derivates, salts and mixtures thereof; and

c) Cystein [X = SH, R1=H, R2 = NH2, R3 = COOH], 3,3'-Dithiodi-propionic acid [X=S-S, R1=H; R2=H; R3= COOH].

C. Method of embodiment A or B wherein in step ii) the predip composition is an aqueous solution with a pH of from -1 to 11.

D. Method of any of the preceding embodiments wherein in step iii) the etching solution is an aqueous solution comprising or consisting of

a) at least one acid;
b) at least one oxidising agent suitable to oxidise copper; preferably, the at least one oxidising agent is selected

from the group consisting of peroxides and superoxides;
c) optionally, at least one source of halide ions;
d) at least one solvent, preferably water;
e) optionally, at least one azole corrosion inhibitor;
f) optionally, at least one polyalkylene compounds; and
g) if the at least one oxidising agent comprises Fe(III) optionally, at least one source of ferrous ions.

E. A method of any of the preceding embodiments further comprising the following step
iv) contacting the copper or copper alloy surface with a post-dip solution.

F. The method of any of the preceding embodiments characterised in that the substrate comprising a copper or copper alloy surface is selected from copper foils, copper alloy foils, printed circuit boards, IC substrates, interposers, copperised semiconductor wafers and copper clad laminates.

G. A method of any of the preceding embodiments for producing cavities in the copper or copper alloy surfaces, wherein a plurality of the cavities is obtuse with respect to the top surface, and a plurality of the cavities are at least 50 nm and less than 500 nm deep.

H. A method of embodiment G for treating an article with a copper or copper alloy surface wherein the article is a patterned sample.

I. The method of embodiment H wherein the change of dimension of the pattern is smaller than 10% of the original value, preferred the change of dimension of the pattern is smaller than 7% of the original value, more preferred the change of dimension of the pattern is smaller than 5% of the original value, most preferred the dimension of the pattern is not changed

J. The method of embodiment I wherein the change of dimension is line width reduction and the line width reduction is smaller than 10% of the original value, preferred the line width reduction is smaller than 7% of the original value, more preferred the line width reduction is smaller than 5% of the original value, most preferred the line width reduction is 0% of the original value.

K. An article comprising a copper or copper alloy surface yielded by a method of any of the preceding embodiments with a copper surface comprising cavities in the copper surface
wherein a plurality of the cavities is obtuse with respect to the top surface, and a plurality of the cavities are at least 50 nm and less than 500 nm deep.

L. An article with a copper surface according to embodiment K wherein the article is a patterned sample.

M. The article of embodiment L wherein the change of dimension of the pattern is smaller than 10% of the original value, preferred the change of dimension of the pattern is smaller than 7% of the original value, more preferred the change of dimension of the pattern is smaller than 5% of the original value, most preferred the dimension of the pattern is not changed

N. The article of embodiment M wherein the change of dimension is line width reduction and the line width reduction is smaller than 10% of the original value, preferred the line width reduction is smaller than 7% of the original value, more preferred the line width reduction is smaller than 5% of the original value, most preferred the line width reduction is 0% of the original value.

O. Use of the article of any of claims K to N in temporary adhesion applications and/or permanent adhesion applications and/or as solder resist pretreatment and as laser direct drilling (LDD) pretreament.

P. Use according to claim O in Metal Mesh Touch Screen.

The following non-limiting examples further illustrate the present invention.

## Examples

The predip compositions were prepared by dissolving all components in water or, if necessary, in dilute acidified

or alkaline solution.

The etching solutions were prepared by dissolving all components in water or if necessary in dilute acidified solution. Electrodeposited (ED) copper foils used in the experiments had an average grain size of 0.5-3 μm as determined by SEM of electro-polished samples.

The adhesion strength values (also referred to as peel strength values) between the treated copper surface and the organic matrix was measured according to the method described in IPC-TM-650 Test Methods Manual Number 2.4.8 revision C.

The smoothness (or roughness) of the outer surface was determined by a scanning atomic force microscope (Digital Instruments, NanoScope equipped with a PointProbe® from Nanosensors with a tip radius of less than 7 nm), scan size: 20 × 20 μm, scan in tapping mode. RSAI values (relative surface area increase) and $S_a$ (averaged roughness) were obtained by these measurements and are provided with the respective examples below.

The microscopic characterisation of the copper surfaces was performed using Carl Zeiss SMT Ltd. EVO15-07.05 or a Helios NanoLab 650 scanning electron microscopes (SEM, both FEI Company). Alternatively, where applicable, a light microscope (Olympus Optical Ltd., BX 60F-3) was used.

To assess the line shape alteration (and thus the retaining of the desired rectangular shape), the top-bottom-difference was measured. The top-bottom-difference was obtained by measuring the width of the respective copper or copper alloy line at the top (widthtop) and the bottom ($width_{bottom}$) in a cross section. The top-bottom-difference is obtained from the following formula:

$$\text{top-bottom-difference} = width_{top} - width_{bottom}$$

Hence, a negative top bottom difference relates to a copper line which was etched predominantly at the top whereas a positive top-bottom-difference means that the etching at the bottom of said copper lines prevailed. Top-bottom-difference of treated copper lines should be as close to zero as such copper lines have a rectangular shape.

The line width reduction was obtained from measuring the size of the copper lines before and after treatment. The smaller said value is the better.

The etch rate was obtained by treating a copper clad laminate for 60 s and measuring the mass before and after etching. The difference thereof can be recalculated to the etch rate for 60 s.

Comparative is sometimes abbreviated herein as comp. and inventive as inv.

Structures for screening

Predip composition

| P# | Compound | Compound selected from group ... of claim 1 | Rests | Acid | Concentration (mmol) | Temperature (°C) | Contact time (s) |
|---|---|---|---|---|---|---|---|
| 1 | Thiourea | a | X = S; R1, R2, R3, R4 = H | NaOH, H2O, formic acid, methansulfon ic acid, gluconic acid | 1 - 150 | 35 - 55 | 30 - 180 |
| 2 | Urea $H_2NC(O)NH_2$ | n/a | n/a | gluconic acid | 150 | 55 | 30-60 |
| 3 | Aminoimino-methanesulfinic acid | b | X = S(O); R1, R2, R3 = H; R5 = OH | H2SO4 | 10 | 35 | 60 |

| | | | | | | | |
|---|---|---|---|---|---|---|---|
| 4 | Formamidine disulfide dihydrochloride | b | X = S-S; R1, R2, R3 = H; R5 = C (NR1R2)=NR3 | H2SO4 | 4 | 35 | 60 |
| 5 | Aminothiazol | b | X = S; R1, R2 = H; R3+R5 = C=C | H2SO4, gluconic acid | 0,1 - 100 | 25 -50 | 30 - 90 |
| 6 | 3,3'-Dithiodi-propionic acid | c | X=S-S, R1=H; R2=H; R3= COOH; | H2SO4 | 5 | 35 | 60 |
| 7 | Bis-(sodium sulfopropyl)-disulfide Na-Salt | c | X=S-S, R1=H; R2=H; R3= SO3Na; | H2SO4 | 1 | 35 | 60 |
| 8 | 3-Nitrobenzene sulfonic acid | d | 3-Nitrobenzene sulfonic acid | H2SO4, | 25 | 55 | 30 -90 |
| 9 | 2-Mercaptoim-idazole | b | X = SH; R1 =H, R2 + R3 = C=C | H2SO4 | 2,5 | 35 | 60 |
| 10 | 2-Mercaptothi-azole | b | X = SH; R1 =H, R2 + R3 = C=C; N-R1R2 = S-R1R2 | H2SO4 | 4 | 35 | 60 |
| 11 | N≡C-S Ammoniumthi-ocyanat | n/a | n/a | H2SO4 | 13 | 35 | 60 |
| 12 | 2-Amino-1,3,4-thiadiazole | b | X = S; R1, R2 =H, R3 + R5 = N=C | H2SO4 | 10 | 35 | 60 |
| 13 | Cystein | c | X = SH, R1=H, R2 = NH2, R3 = COOH | H2SO4 | 8 | 35 | 60 |
| 14 | Mercaptosuc-cinic acid | c | X = SH, R1=COOH, R2=H, R3=COOH | H2SO4 | 3 | 35 | 60 |

Etching solution

| O# | Acid | Oxidizer (Concentration) | additional Additives | Chloride (mg) | Temperature (°C) | Contact time (s) |
|---|---|---|---|---|---|---|
| 1 | H2SO4 | 35% H2O2 (20 - 50 ml/l) | - | 5-35 | 25 - 45 | 10-180 |
| 2 | H2SO4 | NaPS 150 g/l | | 0.1 - 100 | 30 - 35 | 5-60 |
| 3 | H2SO4 | 35% H2O2 (65 ml/l) | Cupraetch DT 40 (40 ml/l) *) | notindicated **) | 30 - 40 | 10-60 |
| 4 | H2SO4 | Fe(III) (15 g/l) | EcoFlash S300 *) | notindicated **) | 25-35 | 5-60 |
| 5 | H2SO4 | Fe(III) (8 g/l) | Cupraetch FH *) | notindicated **) | 30 - 40 | 5-60 |
| 6 | formic Acid | CuCl (35 g/l) | Cupraetch SR *) | notindicated **) | 30 -40 | 5 -60 |
| *) The indicated additives are commercial products from Atotech Deutschland GmbH & Co. KG<br>**) information is not shown e.g. on technical data sheets | | | | | | |

Experimental Table

| Experiment (E#) | Inventive / comparative | Predip composition (P#) | Oxidizer solution (O#) |
|---|---|---|---|
| E1 | Comparative | - | #1 |
| E2 | Comparative | - | #2 |
| E3 | Comparative | - | #3 |
| E4 | Comparative | - | #4 |

(continued)

| Experiment (E#) | Inventive / comparative | Predip composition (P#) | Oxidizer solution (O#) |
|---|---|---|---|
| E5 | Comparative | - | #5 |
| E6 | Comparative | - | #6 |
| E7 | Inventive | #1 (55 mmol, 40s, 35 °C) | #1 |
| E8 | Inventive | #1 (55 mmol, 40s, 35 °C) | #2 |
| E9 | Inventive | #1 (55 mmol, 40s, 35 °C) | #3 |
| E10 | Inventive | #1 (55 mmol, 40s, 35 °C) | #4 |
| E11 | Inventive | #1 (55 mmol, 40s, 35 °C) | #5 |
| E12 | Inventive | #1 (55 mmol, 40s, 35 °C) | #6 |
| E13 | Comparative | #1 (55 mmol, 40s, 35 °C) | - |
| E14 | Comparative | #2 | #1 |
| E15 | Inventive | #3 | #1 |
| E16 | Inventive | #4 | #1 |
| E17 | Inventive | #5 | #1 |
| E18 | Inventive | #6 | #1 |
| E19 | Inventive | #7 | #1 |
| E20 | Inventive | #8 | #1 |
| E21 | Inventive | #9 | #1 |
| E22 | Comparative | #10 | #1 |
| E23 | Comparative | #11 | #1 |
| E24 | Comparative | #12 | #1 |
| E25 | Inventive | #13 | #1 |
| E26 | Inventive | #14 | #1 |

Respective SEM images are shown in Figure 2.

## Claims

1. Method for nano etching of copper or copper alloy surfaces **characterized by** the following method steps:

   i) providing a substrate having at least one copper or copper alloy surface,
   ii) contacting at least a portion of said copper or copper alloy surface with a predip composition,
   iii) contacting at least a portion of said copper or copper alloy surface with an etching solution,

   **characterized in that**

   - the steps are performed subsequently;
   - step ii) is a non-etching step;
   - step iii) is an etching step; and
   - the predip composition comprises at least one sulfur-containing compound selected from the group consisting of

      a) compounds of formula (I)

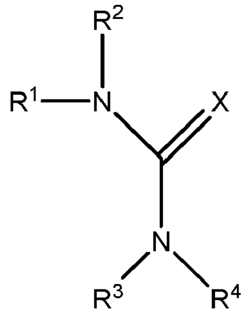

(I),

wherein

X = S or S(O);
$R^1$, $R^2$, $R^3$, $R^4$ = H, C1-C6-alkyl, OH,
derivates, salts and mixtures thereof;

b) compounds of formula (II)

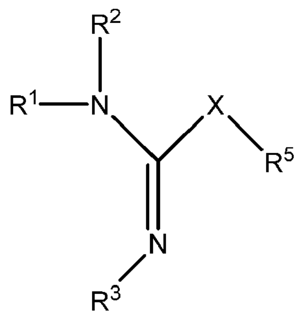

(II)

wherein

X = S, S(O), S-S;
$R^1$, $R^2$, $R^3$ = H, C1-C6-alkyl, OH or $R^1$+$R^3$ = CH=CH,
$R^5$ = H, C1-C6-alkyl, OH,

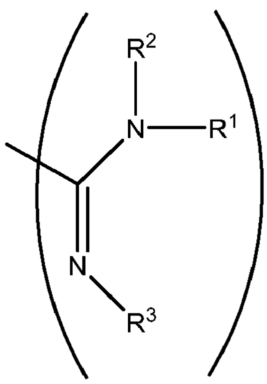

,

or $R^3$+$R^5$ = CH=CH,
derivates, salts and mixtures thereof;

c) compounds of the structure Y-H or $Y_2$ (*thiols or disulfides*) with Y- =

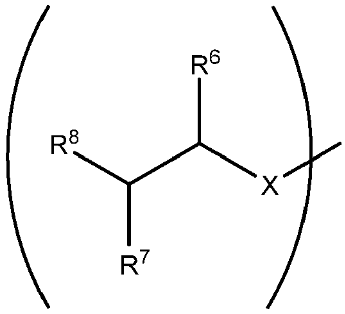

wherein X = S,
$R^6$ = COOH, C1-C6 alkyl; $R^7$ = H, NH2, C1-C6-alkyl; $R^8$ = COOH, SO3H, C1-C3-alkyl and
d) 3-nitrobenzene sulfonic acid.

**2.** Method of claim 1 wherein the at least one sulfur-containing compound is selected from the group consisting of

a) thiourea [X = S; $R^1$, $R^2$, $R^3$, $R^4$ = H],
b) 2-aminothiazole [X = S, $R^1$, $R^2$= H, $R^3$+$R^5$ : -CH=CH-], 2-mer-captoimidazole [X = S, $R^2$, $R^5$ = H, $R^1$+$R^3$ : -CH=CH-], formamidine disulfide (dihydrochloride) (X = S-S, $R^1$, $R^2$, $R^3$ = H, $R^5$ =

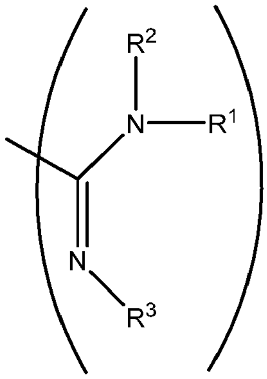

,

formamidine sulfinic acid [X = S(O), $R^1$, $R^2$, $R^3$ = H, $R^5$ = OH], derivates, salts and mixtures thereof; and
c) Cystein [X = SH, R1=H, R2 = NH2, R3 = COOH], 3,3'-Dithiodi-propionic acid [X=S-S, R1=H; R2=H; R3= COOH].

**3.** Method of any of the preceding claims wherein in step iii) the etching solution is an aqueous solution comprising or consisting of

a) at least one acid;
b) at least one oxidising agent suitable to oxidise copper; preferably, the at least one oxidising agent is selected from the group consisting of peroxides and superoxides;
c) optionally, at least one source of halide ions;
d) at least one solvent, preferably water;
e) optionally, at least one azole corrosion inhibitor;
f) optionally, at least one polyalkylene compounds; and
g) if the at least one oxidising agent comprises Fe(III) optionally, at least one source of ferrous ions.

**4.** Method of any of the preceding claims further comprising the following step
iv) contacting the copper or copper alloy surface with a post-dip solution.

**5.** The method of any of the preceding claims **characterised in that** the substrate comprising a copper or copper alloy

surface is selected from copper foils, copper alloy foils, printed circuit boards, IC substrates, interposers, copperised semiconductor wafers and copper clad laminates.

6. A method of any of the preceding claims for producing cavities in the copper or copper alloy surfaces, wherein a plurality of the cavities is obtuse with respect to the top surface, and a plurality of the cavities are at least 50 nm and less than 500 nm deep.

7. A method of claim 6 for treating an article with a copper or copper alloy surface wherein the article is a patterned sample.

8. The method of claim 7 wherein the change of dimension of the pattern is smaller than 10% of the original value, preferred the change of dimension of the pattern is smaller than 7% of the original value, more preferred the change of dimension of the pattern is smaller than 5% of the original value, most preferred the dimension of the pattern is not changed

9. The method of claim 8 wherein the change of dimension is line width reduction and the line width reduction is smaller than 10% of the original value, preferred the line width reduction is smaller than 7% of the original value, more preferred the line width reduction is smaller than 5% of the original value, most preferred the line width reduction is 0% of the original value.

10. An article comprising a copper or copper alloy surface yielded by a method of any of the preceding claims with a copper surface comprising cavities in the copper surface
wherein a plurality of the cavities is obtuse with respect to the top surface, and a plurality of the cavities are at least 50 nm and less than 500 nm deep.

11. An article with a copper surface according to claim 10 wherein the article is a patterned sample.

12. The article of claim 11 wherein the change of dimension of the pattern is smaller than 10% of the original value, preferred the change of dimension of the pattern is smaller than 7% of the original value, more preferred the change of dimension of the pattern is smaller than 5% of the original value, most preferred the dimension of the pattern is not changed

13. The article of claim 12 wherein the change of dimension is line width reduction and the line width reduction is smaller than 10% of the original value, preferred the line width reduction is smaller than 7% of the original value, more preferred the line width reduction is smaller than 5% of the original value, most preferred the line width reduction is 0% of the original value.

14. Use of the article of any of claims 10 to 13 in temporary adhesion applications and/or permanent adhesion applications and/or as solder resist pretreatment and as laser direct drilling (LDD) pretreament.

15. Use according to claim 14 in Metal Mesh Touch Screen.

Figure 1:

1A

1B

1C

1D

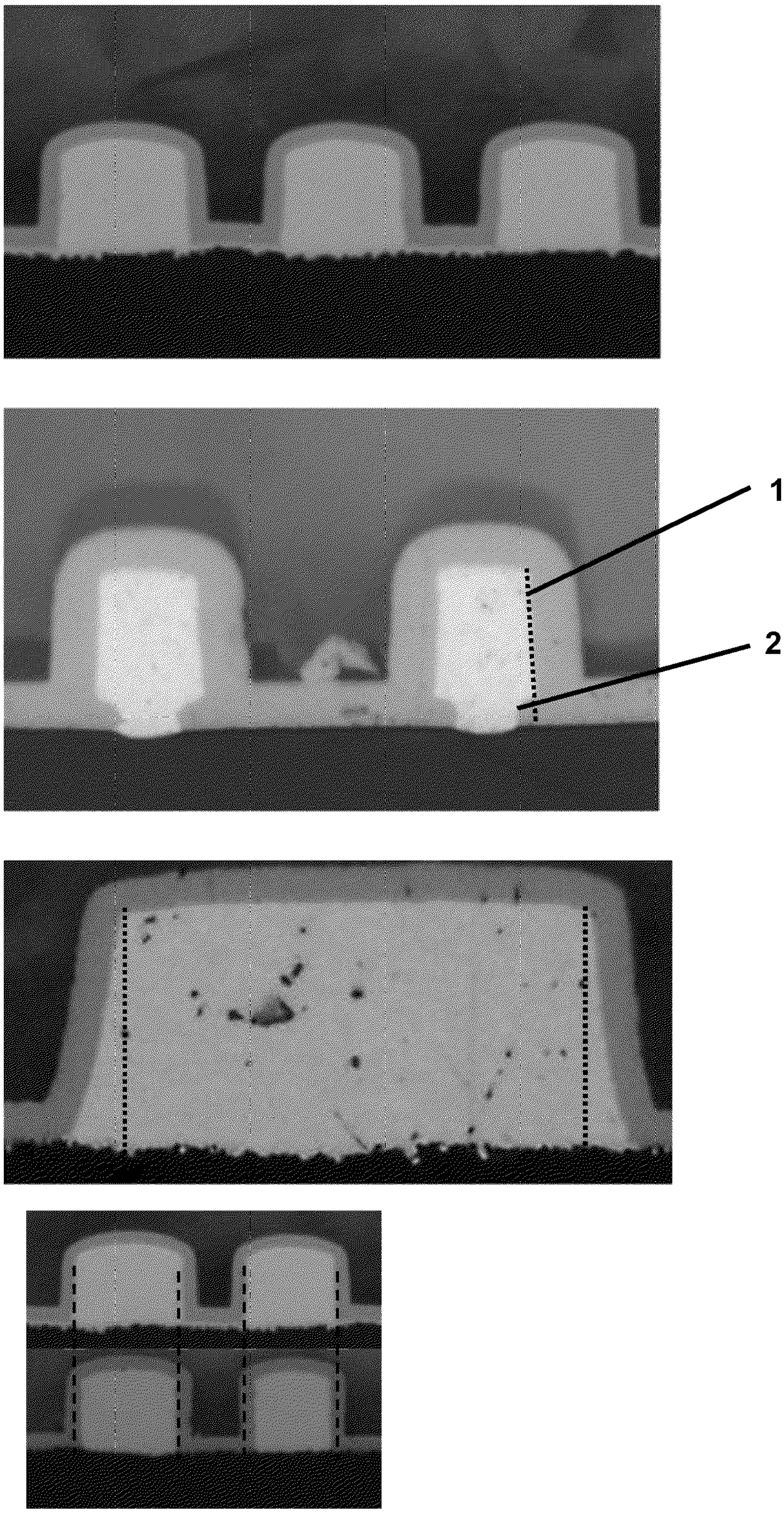

Figure 2:

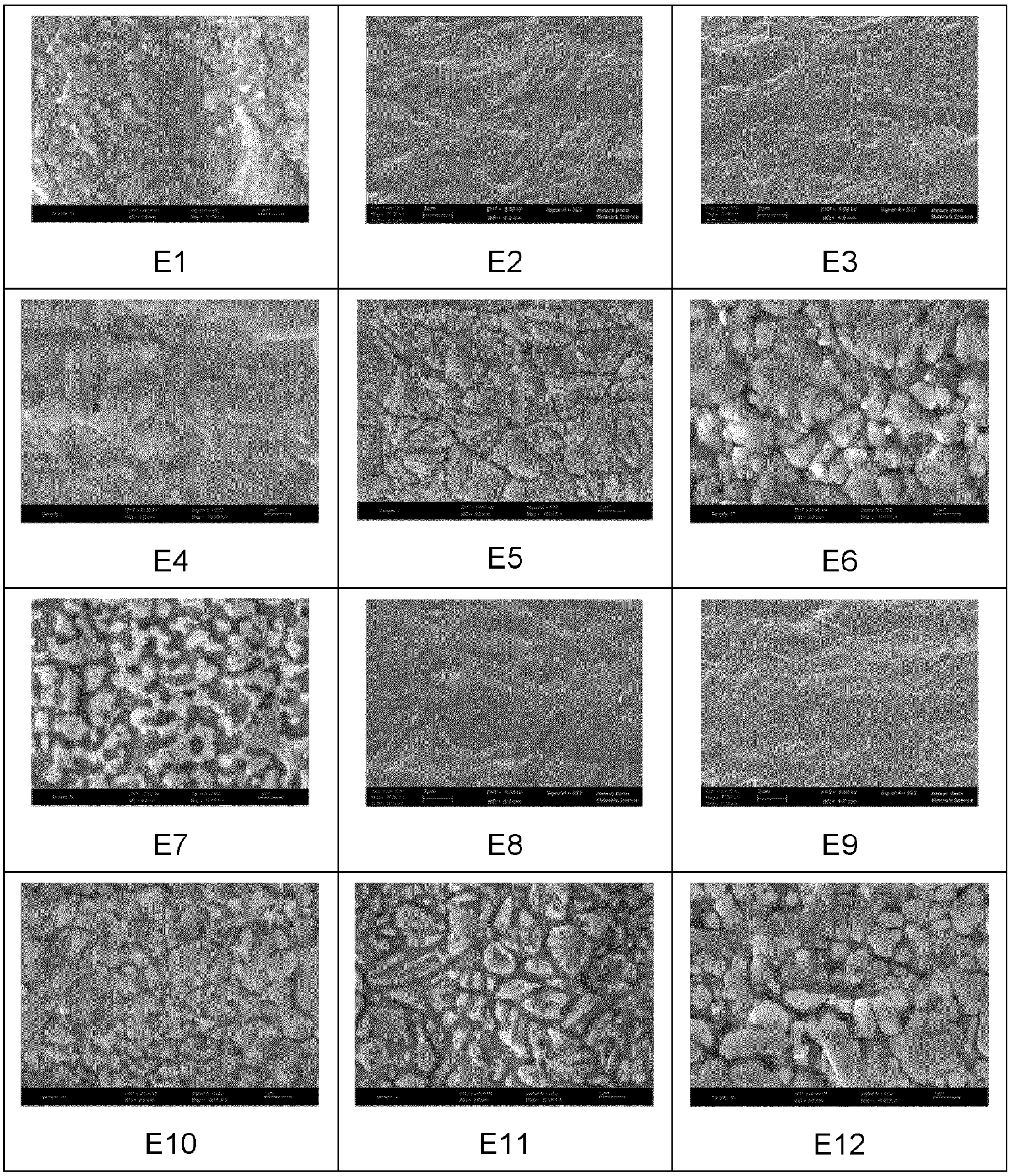

Figure 2 (continued):

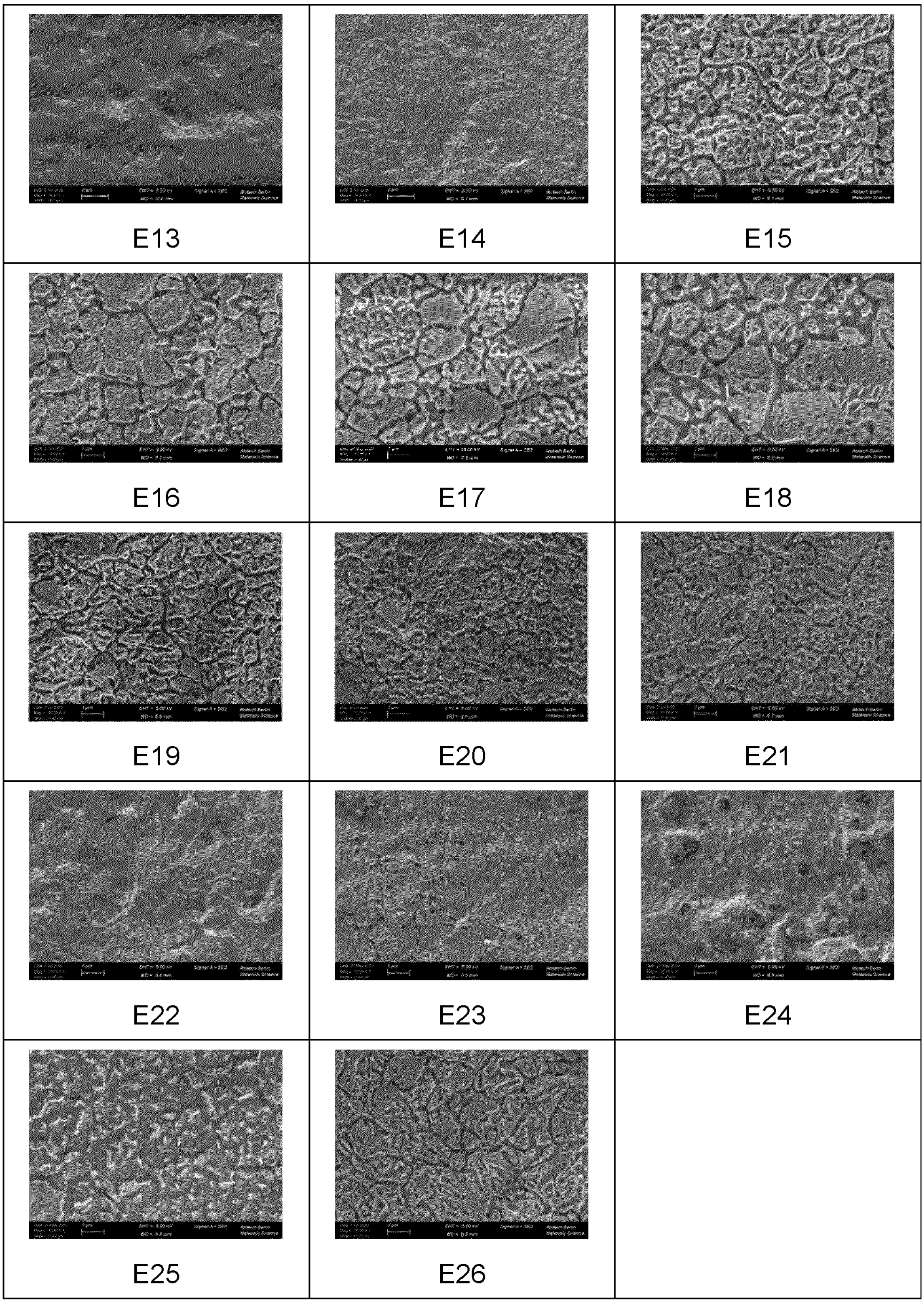

E13 E14 E15
E16 E17 E18
E19 E20 E21
E22 E23 E24
E25 E26

Figure 3

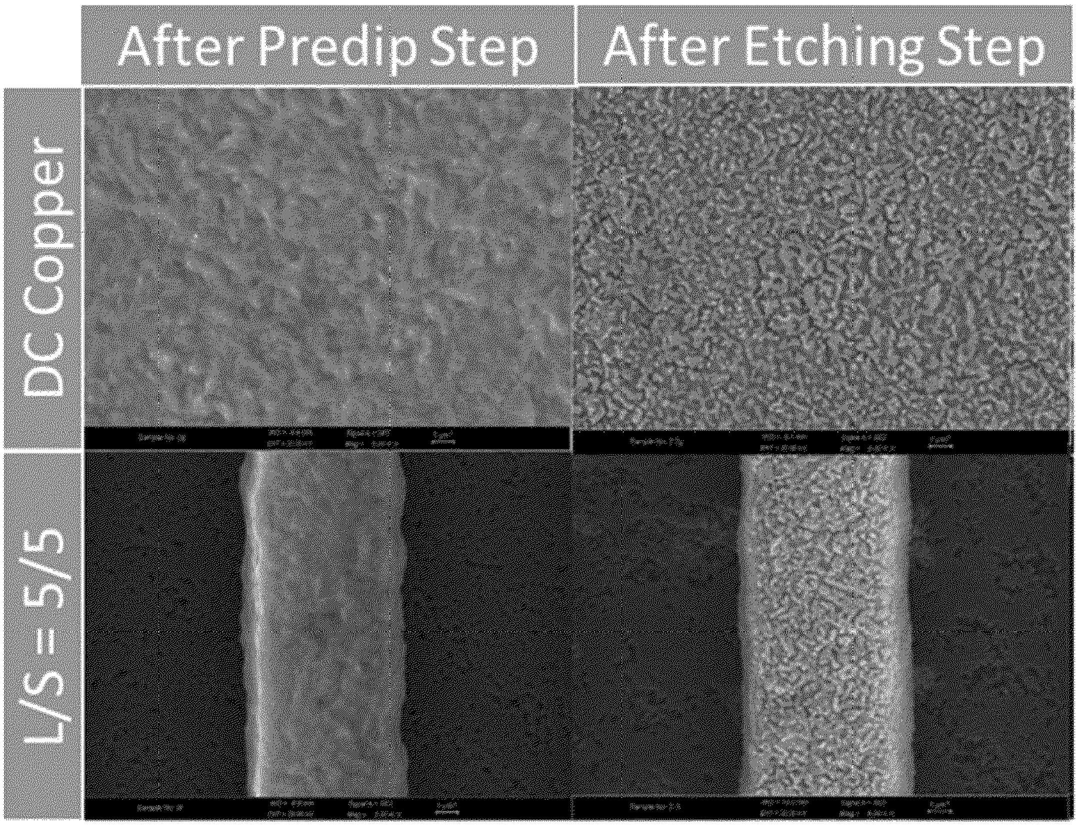

Figure 4:

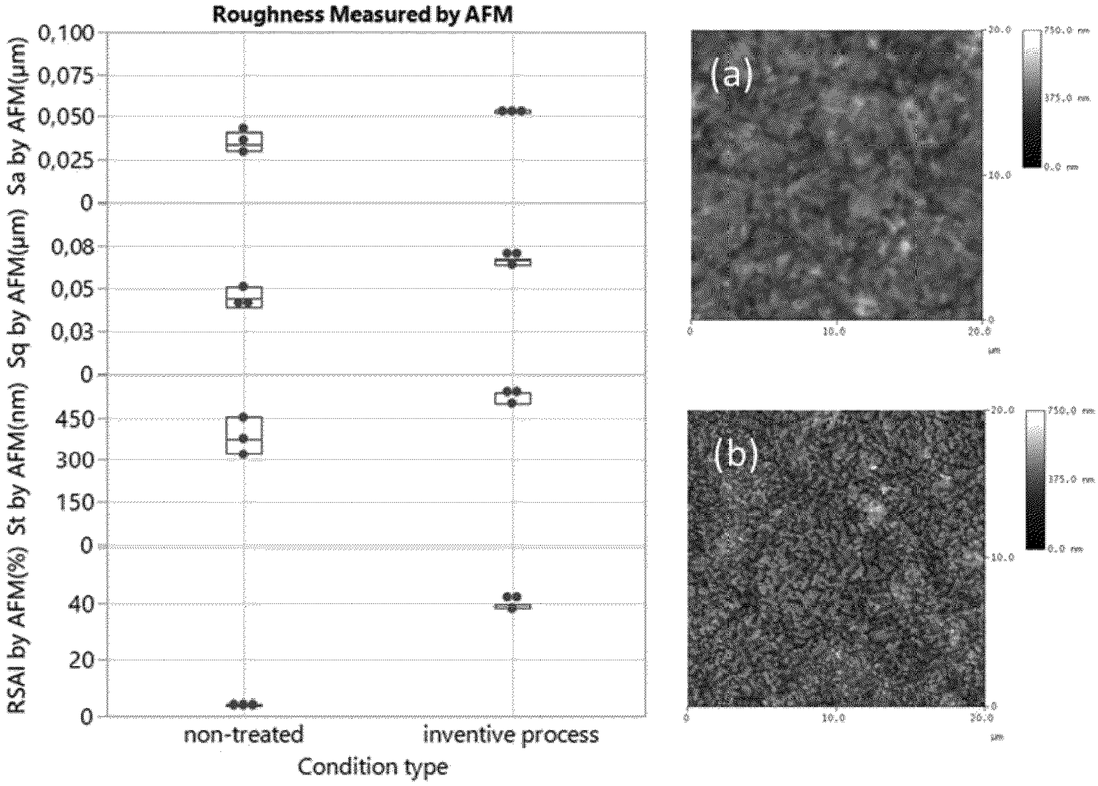
Roughness Measured by AFM
Sa by AFM(µm)
0,100
0,075
0,050
0,025
0
Sq by AFM(µm)
0,08
0,05
0,03
0
St by AFM(nm)
450
300
150
0
RSAI by AFM(%)
40
20
0
non-treated
inventive process
Condition type
(a)
(b)

Figure 5:

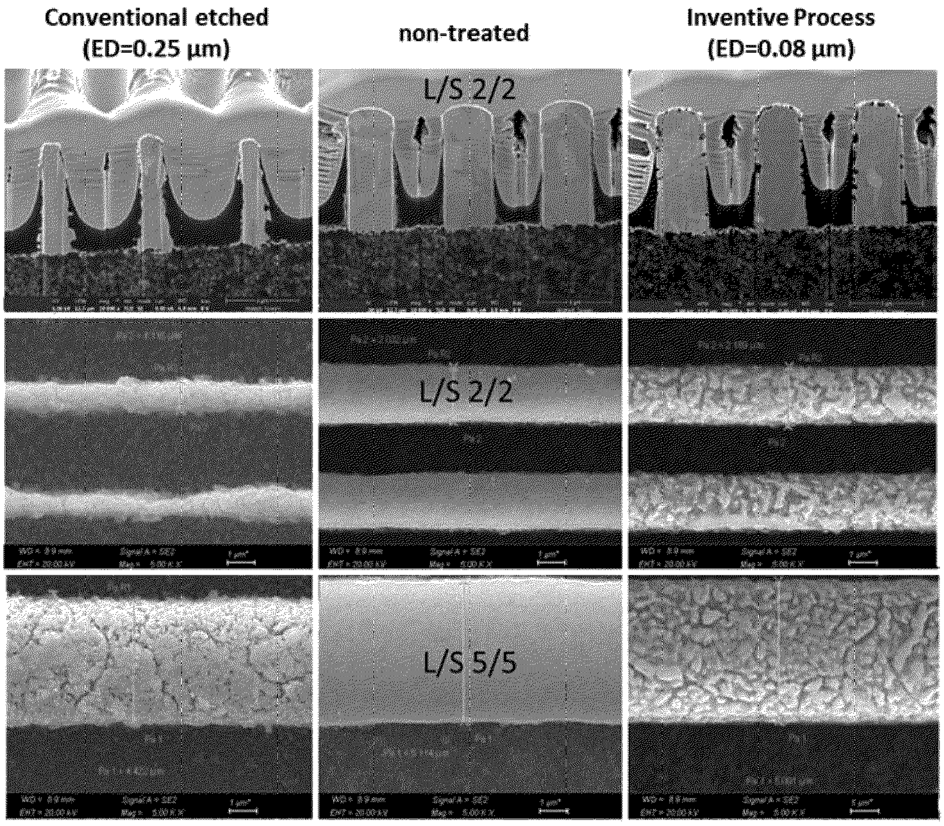
Conventional etched
(ED=0.25 µm)
non-treated
Inventive Process
(ED=0.08 µm)
L/S 2/2
L/S 2/2
L/S 5/5

Figure 6:

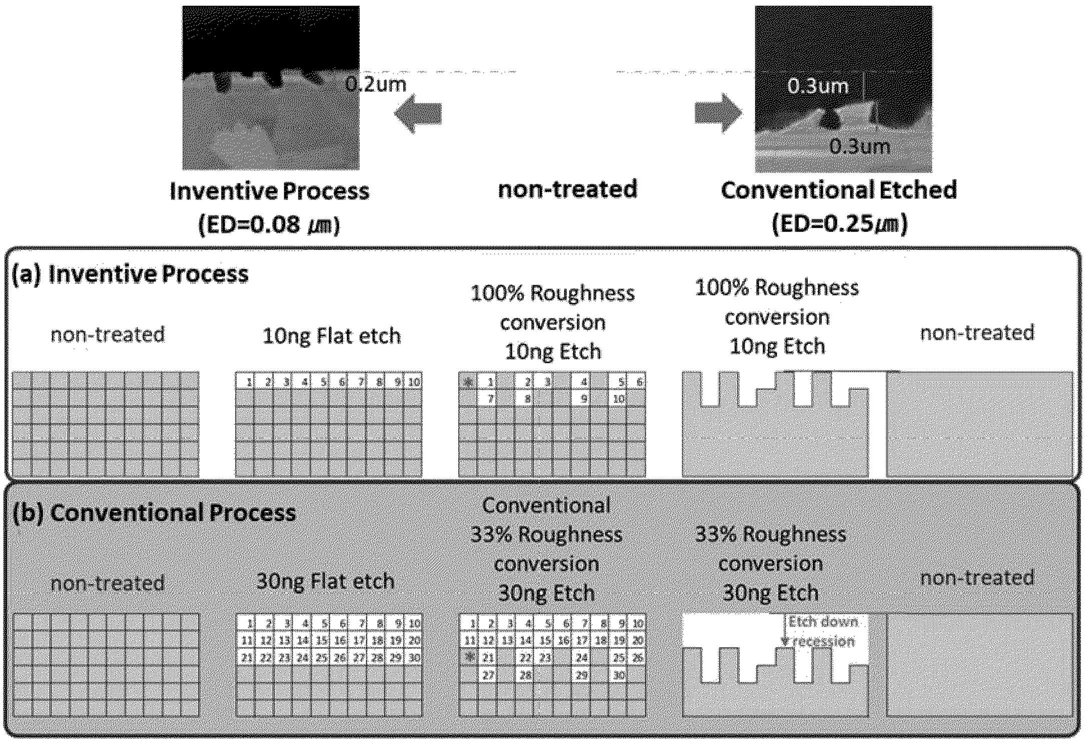
0.2um
0.3um
0.3um
Inventive Process
(ED=0.08 µm)
non-treated
Conventional Etched
(ED=0.25µm)
(a) Inventive Process
non-treated
10ng Flat etch
100% Roughness conversion 10ng Etch
100% Roughness conversion 10ng Etch
non-treated
(b) Conventional Process
non-treated
30ng Flat etch
Conventional 33% Roughness conversion 30ng Etch
33% Roughness conversion 30ng Etch
Etch down recession
non-treated

Figure 7:

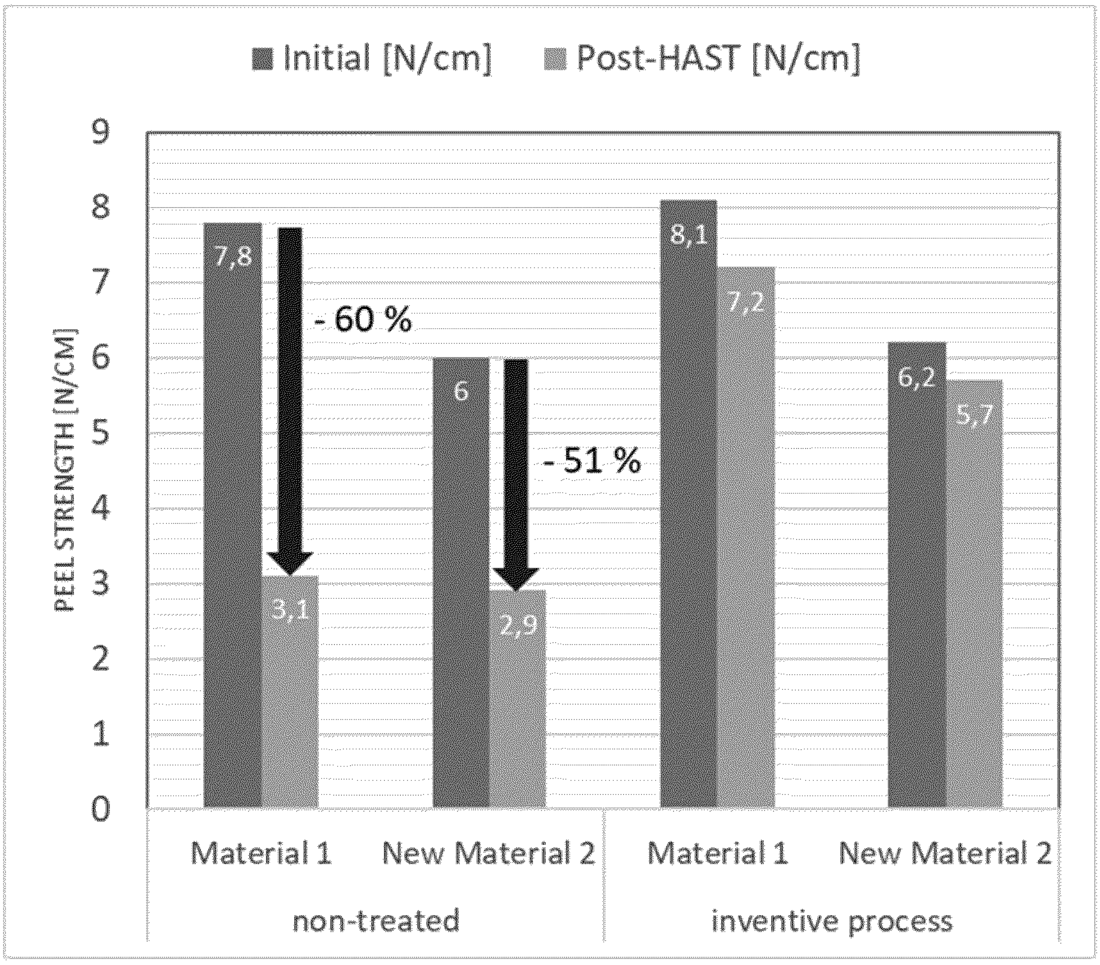
Initial [N/cm]
Post-HAST [N/cm]
PEEL STRENGTH [N/CM]
9
8
7
6
5
4
3
2
1
0
7,8
3,1
- 60 %
6
2,9
- 51 %
8,1
7,2
6,2
5,7
Material 1
New Material 2
Material 1
New Material 2
non-treated
inventive process

Figure 8:

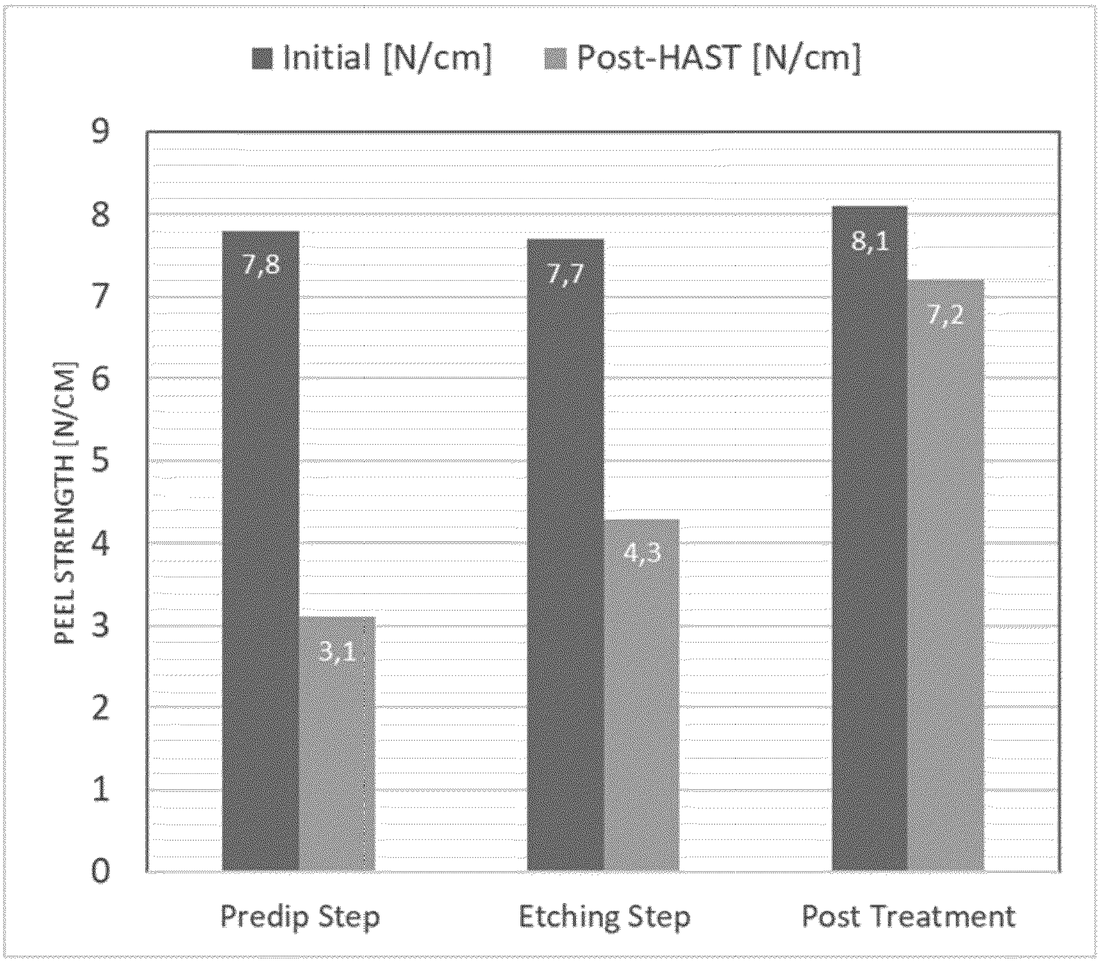
Initial [N/cm]
Post-HAST [N/cm]
PEEL STRENGTH [N/CM]
0
1
2
3
4
5
6
7
8
9
7,8
3,1
7,7
4,3
8,1
7,2
Predip Step
Etching Step
Post Treatment

Figure 9:

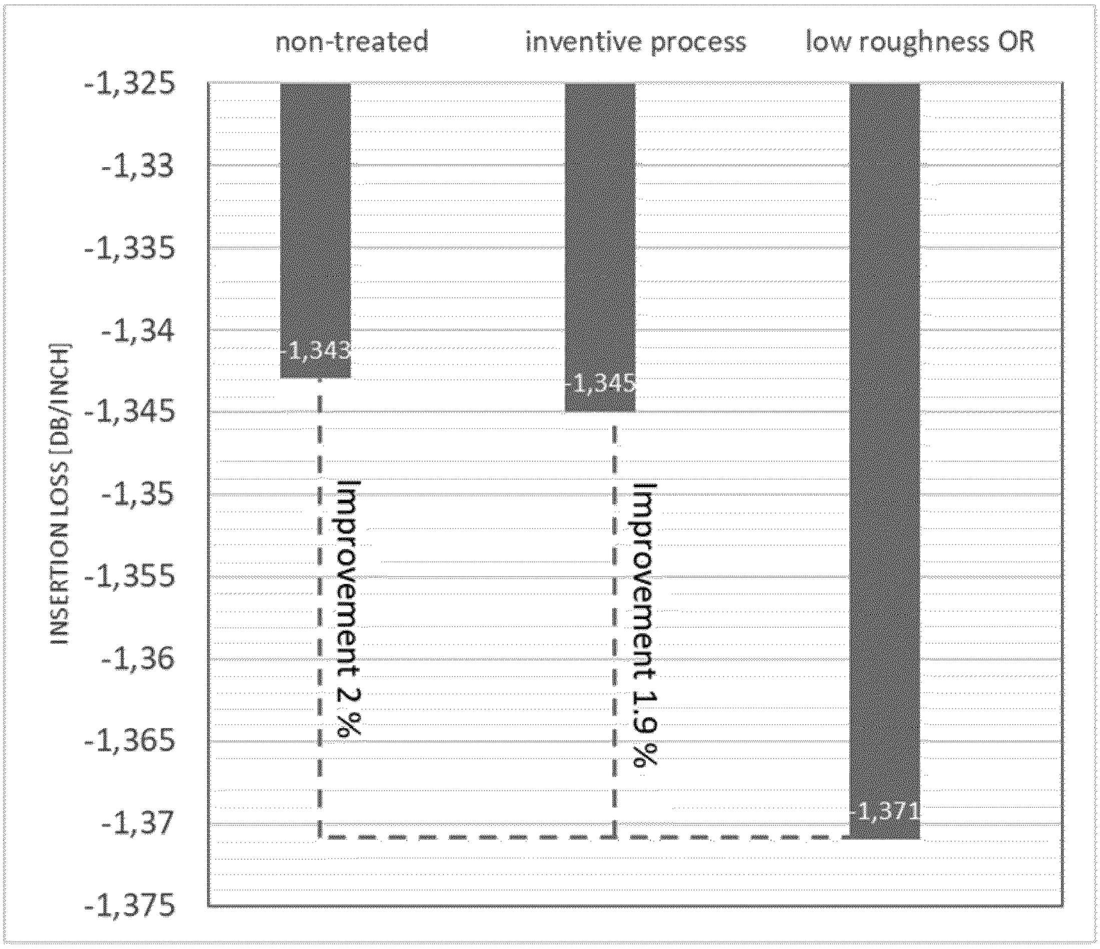
non-treated
inventive process
low roughness OR
-1,325
-1,33
-1,335
-1,34
-1,345
-1,35
-1,355
-1,36
-1,365
-1,37
-1,375
INSERTION LOSS [DB/INCH]
-1,343
-1,345
-1,371
Improvement 2 %
Improvement 1.9 %

Europäisches Patentamt
European Patent Office
Office européen des brevets

# EUROPEAN SEARCH REPORT

Application Number
EP 22 17 3745

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 6 562 149 B1 (GRIESER UDO [DE] ET AL) 13 May 2003 (2003-05-13)<br>* column 1, lines 5-26 *<br>* column 2, lines 29-40 *<br>* column 2, line 43 - column 3, line 11 *<br>* column 3, lines 15-20, 23-41 *<br>* column 4, lines 1-25 *<br>* column 5, lines 43-59 *<br>* column 5, line 64 - column 7, line 7 *<br>----- | 1-14<br>15 | INV.<br>C23F1/18<br>H01L21/3213<br>H05K3/06<br>H05K3/38<br>C23F1/02 |
| X<br>A | US 6 723 385 B1 (GRIESER UDO [DE] ET AL) 20 April 2004 (2004-04-20)<br>* column 1, lines 6-27 *<br>* column 2, lines 46-65 *<br>* column 3, lines 16-44 *<br>* column 4, line 3 - column 5, line 41 *<br>* column 5, line 66 - column 6, line 22 *<br>* column 6, line 28 - column 7, line 48 *<br>----- | 1-5,7<br>15 | |
| X<br>A | EP 1 820 884 A1 (ATOTECH DEUTSCHLAND GMBH [DE]) 22 August 2007 (2007-08-22)<br>* page 2, paragraph 1-2 *<br>* page 3, paragraph 15-20 *<br>* page 3, paragraph 21 - page 4, paragraph 29 *<br>* page 5, paragraph 36-37 *<br>* page 6, paragraph 40 - page 7, paragraph 56 *<br>-----<br>-/-- | 1-3,5-14<br>15 | TECHNICAL FIELDS SEARCHED (IPC)<br>C23F<br>H01L<br>H05K |

The present search report has been drawn up for all claims

1

| Place of search | Date of completion of the search | Examiner |
|---|---|---|
| Munich | 7 October 2022 | Handrea-Haller, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 22 17 3745

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | EP 2 099 268 A1 (ATOTECH DEUTSCHLAND GMBH [DE]) 9 September 2009 (2009-09-09)<br>* page 2, paragraph 1 *<br>* page 3, paragraph 13 - page 4, paragraph 18 *<br>* page 5, paragraph 26-27 *<br>* page 6, paragraph 46-51 *<br>* page 7, paragraph 56-60 *<br>* page 10; table 1; compound E *<br>* figures 2-9; examples 1-2, 4; compound E *<br>* claims 1-2, 21-26, 32-36 *<br>----- | 1,3,5-14<br>15 | |
| X | EP 1 353 539 A2 (SHIPLEY CO LLC [US]) 15 October 2003 (2003-10-15)<br>* page 11, paragraph 78 - page 12, paragraph 80; example 5; tables 5, sample 11 *<br>* claims 1, 4-8 *<br>----- | 1-3,5,7 | |
| | | | TECHNICAL FIELDS SEARCHED (IPC) |

The present search report has been drawn up for all claims

| Place of search | Date of completion of the search | Examiner |
|---|---|---|
| Munich | 7 October 2022 | Handrea-Haller, M |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 2 of 2

## ANNEX TO THE EUROPEAN SEARCH REPORT ON EUROPEAN PATENT APPLICATION NO.

EP 22 17 3745

This annex lists the patent family members relating to the patent documents cited in the above-mentioned European search report. The members are as contained in the European Patent Office EDP file on
The European Patent Office is in no way liable for these particulars which are merely given for the purpose of information.

07-10-2022

| Patent document cited in search report | Publication date | Patent family member(s) | Publication date |
|---|---|---|---|
| US 6562149 B1 | 13-05-2003 | AT 215299 T | 15-04-2002 |
| | | CA 2318784 A1 | 12-08-1999 |
| | | EP 1051888 A1 | 15-11-2000 |
| | | ES 2175954 T3 | 16-11-2002 |
| | | HK 1030717 A1 | 11-05-2001 |
| | | JP 4644365 B2 | 02-03-2011 |
| | | JP 2002503040 A | 29-01-2002 |
| | | TW 460622 B | 21-10-2001 |
| | | US 6562149 B1 | 13-05-2003 |
| | | WO 9940764 A1 | 12-08-1999 |
| US 6723385 B1 | 20-04-2004 | AT 210366 T | 15-12-2001 |
| | | CA 2318862 A1 | 12-08-1999 |
| | | DK 1055355 T3 | 02-04-2002 |
| | | EP 1055355 A1 | 29-11-2000 |
| | | ES 2168019 T3 | 16-05-2002 |
| | | HK 1032507 A1 | 20-07-2001 |
| | | JP 4143262 B2 | 03-09-2008 |
| | | JP 2002503041 A | 29-01-2002 |
| | | TW 470785 B | 01-01-2002 |
| | | US 6723385 B1 | 20-04-2004 |
| | | WO 9940765 A1 | 12-08-1999 |
| EP 1820884 A1 | 22-08-2007 | AT 445031 T | 15-10-2009 |
| | | CN 101379220 A | 04-03-2009 |
| | | EP 1820884 A1 | 22-08-2007 |
| | | JP 5300135 B2 | 25-09-2013 |
| | | JP 5710670 B2 | 30-04-2015 |
| | | JP 2009526909 A | 23-07-2009 |
| | | JP 2013151757 A | 08-08-2013 |
| | | MY 144294 A | 29-08-2011 |
| | | TW 200745379 A | 16-12-2007 |
| | | TW 201529889 A | 01-08-2015 |
| | | US 2010288731 A1 | 18-11-2010 |
| | | US 2016168722 A1 | 16-06-2016 |
| | | US 2016222523 A1 | 04-08-2016 |
| | | WO 2007093284 A1 | 23-08-2007 |
| EP 2099268 A1 | 09-09-2009 | CN 101926235 A | 22-12-2010 |
| | | EP 2099268 A1 | 09-09-2009 |
| | | EP 2248402 A1 | 10-11-2010 |
| | | JP 5538243 B2 | 02-07-2014 |
| | | JP 2011517324 A | 02-06-2011 |
| | | KR 20100126355 A | 01-12-2010 |
| | | TW 200944616 A | 01-11-2009 |
| | | US 2010323099 A1 | 23-12-2010 |

EPO FORM P0459

For more details about this annex : see Official Journal of the European Patent Office, No. 12/82

## ANNEX TO THE EUROPEAN SEARCH REPORT ON EUROPEAN PATENT APPLICATION NO. EP 22 17 3745

This annex lists the patent family members relating to the patent documents cited in the above-mentioned European search report. The members are as contained in the European Patent Office EDP file on
The European Patent Office is in no way liable for these particulars which are merely given for the purpose of information.

07-10-2022

| Patent document cited in search report | Publication date | Patent family member(s) | Publication date |
|---|---|---|---|
| | | WO 2009109391 A1 | 11-09-2009 |
| EP 1353539 A2 | 15-10-2003 | EP 1353539 A2 | 15-10-2003 |
| | | JP 2004040082 A | 05-02-2004 |
| | | KR 20030082389 A | 22-10-2003 |
| | | TW I223977 B | 11-11-2004 |
| | | US 2004022934 A1 | 05-02-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2241653 A
- EP 2754732 A
- WO 2017108513 A
- EP 3034654 A
- WO 0204706 A
- EP 2020055192 A
- EP 2019061526 A
- EP 2476779 B1


### Non-patent literature cited in the description


- **C. F. COOMBS, JR.** Printed Circuits Handbook. 2001, 33.14-33.15, 33.17